# EUROPÄISCHE PATENTSCHRIFT

(11) **EP 1 277 273 B1**
(45) Veröffentlichungstag und Bekanntmachung des Hinweises auf die Patenterteilung: **24.01.2007**
(21) Anmeldenummer: 01919160.0
(22) Anmeldetag: 02.03.2001
(51) Int. Cl.: H03F 1/32

(54) **VERFAHREN UND SENDESCHALTUNG ZUR ERZEUGUNG EINES SENDESIGNALS**
METHOD AND TRANSMITTING CIRCUIT FOR GENERATING A TRANSMISSION SIGNAL
PROCEDE ET CIRCUIT D'EMISSION POUR CREER UN SIGNAL D'EMISSION

(30) Priorität: 03.03.2000 DE 10010635
(43) Veröffentlichungstag der Anmeldung: 22.01.2003
(73) Patentinhaber: SIEMENS AKTIENGESELLSCHAFT, 80333 München (DE)
(72) Erfinder: BURGER, Klaus, 82515 Wolfratshausen (DE); HOFMANN, Ludwig, 85304 Ilmmuenster (DE); KUECHLER, Heinz, 81477 Muenchen (DE); KURPIERS, Alexander, 64285 Darmstadt (DE); MOLIERE, Thomas, 80805 Müenchen (DE); SCHREPFER, Guenter, 82024 Taufkirchen (DE); WILHELM, Hartmut, 81477 Müenchen (DE); ZSCHUNKE, Willmut, 6100 Darmstadt (DE)
(86) Internationale Anmeldenummer: PCT/DE2001/000793
(87) Internationale Veröffentlichungsnummer: WO 2001/065685

(56) Entgegenhaltungen:
- EP-A- 0 431 201
- EP-A- 0 558 793
- WO-A-86/00476
- WO-A-99/18663

## Beschreibung

Die Erfindung betrifft ein Verfahren zur Erzeugung eines amplituden- und winkelmodulierten Sendesignals, bei dem ein winkelmoduliertes Eingangssignal an einen ersten Eingang eines Sendeverstärkers angelegt wird und ein Amplitudenmodulationssignal an zumindest einen zweiten Eingang des Sendeverstärkers angelegt wird und die Amplitude dabei im Sendeverstärker auf das Eingangssignal aufmoduliert wird. Darüber hinaus betrifft die Erfindung eine Sendeschaltung zur Erzeugung eines entsprechenden amplituden- und winkelmodulierten Sendesignals und ein Kommunikationsendgerät mit einer solchen Schaltung.

Derartige Verfahren bzw. Sendeschaltungen werden verwendet, um bei einem möglichst großen Wirkungsgrad und möglichst guter Linearität der Sendeverstärkerschaltung ein Sendesignal mit hoher Sendeleistung zu erzeugen. Insbesondere im Bereich des Mobilfunks ist eines der wesentlichen Gesichtspunkte bei der Entwicklung von Basisstationen und vor allem auch von Mobilfunkgeräten die Optimierung der Sendeschaltung bezüglich der Effizienz und der Linearität der Sendeverstärkung. Zum Ausstrahlen eines Sendesignals wird in diesen Bereichen häufig eine relativ hohe Sendeleistung benötigt. Ein schlechter Wirkungsgrad bei der Verstärkung führt hier zu einer störenden Verlustwärme und, insbesondere bei mobilen Geräten, die batterie- oder akkubetrieben sind, zu einem unbefriedigenden, hohen Stromverbrauch. Ein besonderes Problem hierbei ist, dass einerseits die Sendesignale häufig einen recht großen Dynamikbereich aufweisen, aber andererseits die Sendeendstufe selbst nur für einen schmalen Regel- bzw. Amplitudenbereich bezüglich des Wirkungsgrads optimiert werden kann. Außerdem muss dafür gesorgt werden, dass das Sendesignal bei der Verstärkung möglichst linear umgesetzt wird, und insbesondere in Bezug auf mögliche Verzerrungen und Rauschen durch die Verstärkung noch so rein ist, dass es den strengen Anforderungen genügt, die durch die Mobilfunkstandards vorgegeben sind.

Dem Fachmann ist hierzu allgemein bekannt, das zu sendende Signal nach Amplitude und Phase zu trennen und am Signaleingang des Sendeverstärkers nur das die Winkelmodulation tragende Signal, d.h. ein winkelmoduliertes Eingangssignal, anzulegen und mit dem Sendeverstärker über (mindestens) einen weiteren Eingang, beispielsweise den Eingang für die Versorgungsspannung oder einen Eingang für die Transistorvorspannung, das Signal, welches die Information über die Amplitudenmodulation enthält (im Folgenden das Amplitudenmodulationssignal genannt) anzulegen. Dabei wird darauf geachtet, dass das winkelmodulierte Eingangssignal und das Amplitudenmodulationssignal zeitlich so zueinander passend angelegt werden, dass die ursprüngliche Signalform wieder entsteht. Bei diesem Verfahren wird also aus dem amplituden- und winkelmodulierten Signal zunächst die.Hüllkurve entfernt und im Sendeverstärker wieder hergestellt. Das Verfahren wird daher allgemein auch "Envelope Elimination and Restoration" (EER) genannt. Das Verfahren hat den Vorteil, dass das winkelmodulierte Eingangssignal eine konstante Amplitude aufweist und der Sendeverstärker somit genau auf diese Amplitude wirkungsgradoptimiert und insbesondere in Sättigung betrieben werden kann. Das Amplitudenmodulationssignal, welches die Versorgungsspannung und/oder die Vorspannung des Sendeverstärkers moduliert, kann separat geeignet verstärkt werden, so das insgesamt ein sehr hoher Wirkungsgrad erreicht wird. Dies setzt selbstverständlich voraus, dass das Amplitudenmodulationssignal, d.h. die schwankende Versorgungsspannung bzw. Vorspannung des Sendeverstärkers, ihrerseits mit gutem Wirkungsgrad verstärkt bzw. aus einer festen Spannung erzeugt werden kann.

Sofern die Amplitudeninformation und die Winkelinformation getrennt vorliegen, können das winkelmodulierte Eingangssignal und das Amplitudenmodulationssignal auch getrennt erzeugt werden. In diesem Fall ist eine Elimination nicht mehr notwendig, sondern die einzelnen Bestandteile werden separat erzeugt und behandelt und erst am Sendeverstärker zusammengeführt.

Unter "Winkelmodulation" ist im Übrigen der Oberbegriff für eine Phasen- und Frequenzmodulation zu verstehen. Der Begriff "Winkel" steht dabei stellvertretend für die Größen "Phase" oder "Momentanfrequenz" (zeitliche Ableitung der Phase).

Typische Verfahren, die Amplitude am Sendeverstärker zu modulieren, bestehen darin, die Versorgungsspannung oder den Transistorarbeitspunkt zu variieren. In der Regel ist jedoch der Zusammenhang zur Ausgangsspannung in beiden Fällen nicht linear. Zudem hängt die Phasendrehung von der Amplitude ab, was üblicherweise als AM/PM-Konversion bekannt ist. Mit geeigneten Regelschleifen lässt sich der Sendeverstärker linearisieren.

Eine Möglichkeit zur Erzeugung eines Amplitudenmodulationssignals mit geeignet hoher Leistung besteht darin, das Amplitudenmodulationssignal mit einem Schaltverstärker, zum Beispiel einem DC/DC-Konverter, zu erzeugen. Derartige Schaltverstärker haben zwar den Vorteil eines großen Wirkungsgrads, zumindest bei hoher abgegebener Leistung. Andererseits werden aber durch die Schaltfrequenz auf dem Signal Störungen erzeugt, die durch nachgeschaltete Tiefpassfilter wieder eliminiert werden müssen. Dies führt zu einer begrenzten Bandbreite und unter Umständen zu einer Verfälschung des Amplituden-modulationssignals, was in der Folge zu einer Verfälschung des modulierten Sendesignals führt.

Die WO 99 18663 A offenbart ein Verfahren sowie eine Vorrichtung zur Erzeugung eines amplituden- und winkelmodulierten Sendesignals, bei dem bzw. der ein winkelmoduliertes Eingangssignal an einen ersten Eingang eines Sendeverstärkers angelegt wird und ein Amplitudenmodulationssignal an zumindest einen zweiten Eingang des Sendeverstärkers angelegt wird und die Amplitude dabei im Sendeverstärker auf das Eingangssignal aufmoduliert wird, wobei das Amplitudenmodulationssignal in einen niederfrequenten Anteil und einen höherfrequenten Anteil aufgeteilt bearbeitet wird und diebeiden Anteile des Amplitudenmodulationssignals vor dem zweiten Eingang des Sendeverstärkers zusammengeführt werden und dabei beide Anteile geregelt werden.

Es ist Aufgabe der vorliegenden Erfindung, ein Verfahren und eine Sendeschaltung anzugeben, die auf möglichst einfache, kostengünstige und effiziente Weise die Erzeugung eines möglichst reinen Sendesignals über einen großen Dynamikbereich ermöglicht.

Diese Aufgabe wird durch ein Verfahren gemäß Patentanspruch 1 und durch eine Sendeschaltung gemäß Patentanspruch 18 gelöst.

Die Erfindung hat besondere Vorteile bei Verwendungen in Kommunikationsendgeräten, insbesondere in Mobilfunkgeräten. Sie ist jedoch nicht auf eine solche Anwendung beschränkt.

Bei dem erfindungsgemäßen Verfahren wird das Amplitudenmodulationssignal zunächst in einen niederfrequenten Anteil und einen höherfrequenten Anteil aufgeteilt bearbeitet. Die Aufteilung ist variabel. Der niederfrequente Anteil besteht beispielsweise aus einem Anteil mit Frequenzen von unter 1 MHz. Dementsprechend deckt der höherfrequente Anteil den oberen Bereich, beispielsweise zwischen 1 MHz und 7 MHz ab. Der niederfrequente Anteil kann aber auch nur den reinen Gleichspannungsanteil des Amplitudenmodulationssignals umfassen.

Der Begriff "aufgeteilt" ist hier nicht unbedingt nur so zu verstehen, dass tatsächlich die Anteile vollständig getrennt werden. Es ist hierunter auch ein Fall zu verstehen, in dem beispielsweise der niederfrequente Anteil separat behandelt wird und innerhalb der Behandlung die höheren Frequenzen ausgefiltert werden und der höherfrequente Anteil die gesamte Bandbreite des Amplitudenmodulationssignals beinhaltet und somit auch die höheren Frequenzen enthält. Ebenso ist die Aufteilung des Amplitudenmodulationssignals nicht nur so möglich, dass beispielsweise zunächst ein vollständiges analoges Amplitudenmodulationssignal über die gesamte Bandbreite vorliegt, welches z.B. durch geeignete Filter getrennt wird, sondern es kann eine Aufteilung auch bereits bei einem in digitaler Form vorliegenden Amplitudenmodulationssignal, beispielsweise in einem digitalen Signalprozessor (DSP) des Geräts, erfolgen. Es werden dann die beiden digitalen Signale für den niederfrequenten Anteil und den höherfrequenten Anteil des Modulationssignals getrennt behandelt, beispielsweise getrennt analogisiert und verstärkt.

Insbesondere in Mobilfunkgeräten, aber auch in vielen anderen Geräten, werden die zu sendenden Informationen ohnehin auf digitaler Ebene in einem digitalen Signalprozessor des Geräts erzeugt.

Die beiden Anteile des Amplitudenmodulationssignals werden dann entweder vor dem Eingang des Sendeverstärkers zusammengeführt, z.B. addiert, so dass dann beispielsweise die Versorgungsspannung oder die Vorspannung des Sendeverstärkers entsprechend über die gesamte Bandbreite mit einem verstärkten Signal moduliert wird. Eine Alternative hierzu ist es, die beiden Anteile des Amplitudenmodulationssignals auf verschiedene Eingänge des Sendeverstärkers zu schalten, beispielsweise den niederfrequenten Anteil quasi als mittlere Versorgungsspannung auf den Versorgungsspannungseingang des Sendeverstärkers zu geben und den höherfrequenten Anteil an die Vorspannung des Sendeverstärkers anzulegen, wodurch insgesamt eine Amplitudenmodulation des Eingangssignals in der gesamten Bandbreite erzeugt wird.

Erfindungsgemäß wird dabei zumindest einer der beiden Anteile geregelt. Hierzu wird vorzugsweise eine den Sendeverstärker umfassende Regelschleife verwendet, d.h. das Amplitudenmodulationssignal bzw. der betreffende Anteil des Amplitudenmodulationssignals wird mit dem hüllkurvendemodulierten Ausgangssignal des Sendeverstärkers verglichen.

Die Aufteilung in einen niederfrequenten und einen höherfrequenten Anteil hat hierbei folgende Vorteile: Der niederfrequente Anteil transportiert den größten Teil der benötigten Leistung an den Sendeverstärker. Er kann daher über hocheffiziente Mittel hergestellt werden, wobei die Anforderung an die Geschwindigkeit gering ist. Das heißt, es kann hierbei beispielsweise ein Schaltverstärker mit hohem Wirkungsgrad, aber geringer Bandbreite genutzt werden. Der hochfrequente Anteil, der dagegen eine geringe Leistung transportiert, kann über eine breitbandige Schaltung behandelt werden, wobei hier wiederum die Anforderungen an den Wirkungsgrad nicht so hoch sind, da bei der benötigten geringen Leistung Verluste nicht so stark ins Gewicht fallen.

Eine geeignete Sendeschaltung zur Erzeugung eines solchen amplituden- und winkelmodulierten Sendesignals muss zum einen einen Sendeverstärker aufweisen. Zum anderen werden Mittel zur Erzeugung eines winkelmodulierten Eingangssignals benötigt, welche derart aufgebaut und/oder angeordnet sind, dass das winkelmodulierte Eingangssignal an einem ersten Eingang des Sendeverstärkers anliegt. Darüber hinaus weist die Sendeschaltung Mittel zur Erzeugung eines Amplitudenmodulationssignals auf, welche derart aufgebaut und/oder angeordnet sind, dass das Amplitudenmodulationssignal an zumindest einem zweiten Eingang des Sendeverstärkers anliegt und dabei die Amplitude im Sendeverstärker auf das Eingangssignal aufmoduliert wird. Diese Mittel zur Erzeugung des Amplitudenmodulationssignals müssen entsprechende Mittel zur getrennten Bearbeitung des Amplitudenmodulationssignals in einem niederfrequenten Anteil und einem höherfrequenten Anteil aufweisen. Außerdem werden Mittel zum Zusammenführen der beiden Anteile des Amplitudenmodulationssignals vor dem zweiten Eingang des Sendeverstärkers benötigt, oder es müssen alternativ Mittel zum Zusammenführen der beiden Anteile des Amplitudenmodulationssignals im Sendeverstärker über verschiedene Eingänge des Sendeverstärkers existieren. Erfindungsgemäß sind außerdem geeignete Mittel, z.B. eine Regelschleife, zum Regeln zumindest eines der beiden Anteile des Amplitudenmodulationssignals notwendig.

Bei einem besonders bevorzugten Ausführungsbeispiel werden beide Anteile des Amplitudenmodulationssignals geregelt, d.h. die aktuelle Amplitude des Ausgangssignals des Sendeverstärkers wird so zurückgekoppelt, dass das gesamte Amplitudenmodulationssignal mit diesem rückgekoppelten Signal verglichen wird. Anschließend wird beispielsweise das Differenzsignal in einen niederfrequenten und einen höherfrequenten Anteil zerlegt, getrennt voneinander bearbeitet und zur Erzeugung des am Sendeverstärker anliegenden höherfrequenten Anteils und des niederfrequenten Anteils des Amplitudenmodulationssignals verstärkt.

Bei einer alternativen bevorzugten Ausführungsform wird nur einer der beiden Anteile geregelt und der andere Anteil wird zumindest zeitweise gesteuert. So kann beispielsweise bei sehr großer Modulationsbreite nur der niederfrequente Anteil der Modulation innerhalb einer Regelschleife geführt werden, wogegen der höherfrequente Anteil nur gesteuert und beispielsweise erst nach dem Schleifenfilter, welcher den niederfrequenten Anteil separiert, dem Sendeverstärker zugeführt wird. Wegen der niedrigen Bandbreite der Regelung lässt sich hier die Stabilität des geschlossenen Regelkreises vergleichsweise leicht gewährleisten.

Umgekehrt kann auch allein der niederfrequente Anteil, beispielsweise als mittlere Versorgungsspannung, weitgehend nur gesteuert werden. Insbesondere bietet es sich hierbei an, geeignete Schaltmittel vorzusehen, um so beispielsweise den niederfrequenten Anteil in Abhängigkeit von einer gewünschten mittleren Sendeleistung (des Sendeleistungspegels) als Versorgungsspannung für den Sendeverstärker auf einen bestimmten Wert zu regeln und anschließend die Regelung abzuschalten und lediglich entsprechend diesem Wert zu steuern.

Bei vielen Anwendungen lässt sich die Sendeleistung der erforderlichen Reichweite anpassen. Beim Mobilfunkstandard GSM gibt es dafür beispielsweise den sogenannten "Power-Control-Level". Weiterhin wird zur Vermeidung von Nachbarkanalstörungen, welche durch einen burstweisen Betrieb hervorgerufen werden, die Sendeleistung zum Burstbeginn langsam von 0 auf den Zielwert gebracht und am Burstende langsam heruntergefahren. Dieses Verfahren ist als sogenanntes "Power-Ramping" bekannt. Das Power-Ramping und der "Power-Control-Level" sind Beispiele für den hier verwendeten Ausdruck "Sendeleistungspegel". Der Begriff ist aber nicht darauf beschränkt und soll eine wertkontinuierliche Leistungseinstellung einschließen.

Eine solche vorübergehende Regelung zum Einstellen des Leistungspegels bietet sich besonders an, wenn Abschnitte mit bekannter Leistung, zum Beispiel Tailbits, Trainings- oder Synchronisationssequenzen gesendet werden. Wenn die relativ langsame Einstellung der mittleren Sendeleistung über die Versorgungsspannung nicht exakt ist oder Veränderungen nicht schnell genug folgen können, so kann die schnelle Einstellung die Abweichungen der langsamen Einstellung kompensieren, d.h. über die Regelung für den höherfrequenten Anteil werden Fehler in der Steuerung des niederfrequenten Anteils wieder ausgeglichen.

Insgesamt kann durch die Verwendung von Regelschleifen die Genauigkeit der Modulation weitgehend auch bei sich verändernden Sendeverstärkereigenschaften aufrechterhalten werden. Die Anforderung an die Genauigkeit des niederfrequenten Regelkreises ist klein. Fehler werden durch den breitbandigen Regelkreis ausgeglichen, welcher die höherfrequenten Anteile des Signals enthält. In die Regelkreise können außerdem Mittel zur bereichsweisen Korrektur einer Nichtlinearität in einer Verstärkungskennlinie des Sendeverstärkers eingebaut werden. So ist es zum Beispiel möglich, in Abhängigkeit von einem eingestellten Sendeleistungspegel verschiedene Parameter, beispielsweise die Verstärkung oder die Filtercharakteristik eines in einem der Regelkreise oder in beiden Regelkreisen angeordneten Reglers so anzupassen, dass in einem bestimmten Bereich um den gewünschten Sendeleistungspegel die Amplitude innerhalb des Regelkreises derart verstärkt oder gedämpft wird, dass die Nichtlinearität der Verstärkungskennlinie in diesem Bereich ausgeglichen wird.

Die Verwendung eines DC/DC-Konverters, beispielsweise in Form eines Schaltverstärkers mit Pulsweitenmodulation, zur Verstärkung des niederfrequenten Anteils des Amplitudenmodulationssignals hat den Vorteil, dass hiermit ein besserer Wirkungsgrad erzielt wird als bei einem üblichen Längsregler oder Operationsverstärker. Die Bandbreite eines solchen Schaltverstärkers ist umso größer, je höher die Schaltfrequenz ist, denn hinter den Schaltverstärker wird notwendigerweise ein Tiefpass geschaltet, dessen Eckfrequenz so gewählt wird, dass er die störenden Anteile im Spektrum der Pulsmodulation wie die Schaltfrequenz und deren Oberschwingungen unterdrückt. Eine hohe Schaltfrequenz führt aber insbesondere durch das Umladen der Gates der im Schaltverstärker verschalteten FETs zu einer beträchtlichen Verlustleistung, und zwar auch dann, wenn nur eine niedrige Spannung erzeugt werden soll und die abgenommene Leistung gering ist. Der Wirkungsgrad des Schaltverstärkers, d.h. das Verhältnis von aufgenommener zu abgegebener elektrischer Leistung, wird unterhalb einer bestimmten abgenommenen Leistung schlechter als die eines Längsreglers oder Operationsverstärkers.

Ein hoher Wirkungsgrad kann bei niedriger abgenommener Leistung mit einer vorteilhaften Ausführung erzielt werden, bei der der DC/DC-Konverter unterschiedlich große Transistoren zum Schalten aufweist und/oder DC/DC-Konverter mit unterschiedlicher Transistorgröße kombiniert werden und/oder je nach Betriebszustand unterschiedlich viele Transistoren aktiv sind. Bei niedriger Ausgangsspannung, wenn nur geringe Lastströme fließen, werden nur kleine Transistoren betrieben, bei denen nur eine niedrige Kapazität umgeladen werden muss. Zwar ist bei diesen Transistoren der Durchlasswiderstand höher, aber bei den niedrigen Strömen sind die dadurch bedingten Verluste geringer als die Verluste, die beim Schalten großer Transistoren anfielen. Bei hoher Last werden weitere Transistoren aktiviert, und/oder es wird mit größeren Transistoren anstelle kleiner Transistoren geschaltet. Dadurch kann dann auch bei einem hohen Laststrom der Spannungsabfall an den Transistoren niedrig gehalten werden.

Ein weiteres Problem besteht darin, dass zwar bei mittlerer und hoher Ausgangsspannung bei einer in der Sättigung betriebenen Sendeendstufe ein annäherungsweise linearer Zusammenhang zwischen der Ausgangsspannung und der Versorgungsspannung der Sendeendstufe erreicht werden kann. In diesem Bereich lässt sich also die Ausgangspannung der Sendeendstufe gut steuern und eine Regelschleife zur Linearisierung ist prinzipiell verzichtbar. Bei nur niedriger Ausgangsspannung ist die Kennlinie dagegen gekrümmt, d.h. es ist eine Linearisierung der Verstärkung der Sendeendstufe durch eine Regelschleife notwendig. Für den vorgesehenen Zweck der Modulation des Eingangssignals durch das auf den Versorgungsspannungseingang oder den Vorspannungseingang aufgegebene Amplitudenmodulationssignal ist dabei eine ausreichend schnelle und stabile Regelschleife erforderlich, was wiederum eine große Bandbreite und eine niedrige Gruppenlaufzeit erfordert. Ein Schaltverstärker kann die erforderliche Bandbreite in den meisten Fällen nicht erreichen.

Daher ist es besonders vorteilhaft, insbesondere wegen des geringen Wirkungsgrads eines Schaltverstärkers bei nur geringen Leistungen, beispielsweise auch für die Verstärkung des niederfrequenten Anteils, einen Verstärker mit zwei verschiedenen Betriebsarten zu verwenden. Hierzu könnte ein DC/DC-Konverter verwendet werden, der nur in einem Teilbereich der Ausgangsspannung wie ein Schaltverstärker arbeitet. Insbesondere in den Bereichen, in denen ein konventioneller Verstärker oder Längsregler einen besseren Wirkungsgrad bieten würde, schaltet dieser Verstärker nicht mehr, sondern drosselt oder verstärkt ähnlich einem Längsregler oder einem konventionellen Verstärker. Dadurch entfällt die Verlustleistung durch den Takt und das mit ihm erfolgende Umladen. Ein Tiefpassfilter hinter einem solchen Konverter kann entfallen oder in seiner Grenzfrequenz geändert werden, so dass eine größere Bandbreite möglich wird. Wenn der Konverter in dieser nichtschaltenden Betriebsart Teil einer Regelschleife ist, dann wird eine eventuelle Nichtlinearität von ihm zusammen mit der Nichtlinearität der Sendeendstufe ausgeregelt, so dass je nach Anwendung ein nichtlineares Verhalten in dieser Betriebsart akzeptabel ist.

Ein ähnlicher Zweck wird erreicht, wenn anstelle nur eines Schaltverstärkers eine Verstärkereinheit mit einer Kombination aus einem Schaltverstärker und einem nichtschaltenden Verstärker konventioneller Bauart, vorzugsweise mit höherer Bandbreite, verwendet wird. Hierbei gibt es wiederum drei Betriebsmöglichkeiten. Entweder wird nur der Schaltverstärker oder nur der konventionelle Verstärker betrieben, wobei entsprechend der benötigten Leistung zwischen dem einen und dem anderen Verstärker umgeschaltet wird.

Die zweite Möglichkeit besteht darin, dem Schaltverstärker einen Längsregler nachzuschalten. Insbesondere bei niedriger Last schaltet der DC/DC-Konverter einfach durch oder wird überbrückt, so dass keine Verluste durch das Schalten anfallen. Der nachfolgende Längsregler stellt die gewünschte Ausgangsspannung ein. Um je nach Betriebsart Verluste am Längsregler zu vermeiden, kann auch für ihn eine Überbrückung vorgesehen werden. Diese Anordnung kombiniert die Vorteile von DC/DC-Konverter und Längsregler, nämlich hoher Wirkungsgrad und Geschwindigkeit. Der DC/DC-Konverter folgt im Rahmen seiner Bandbreite der Hüllkurve, beispielsweise ähnlich wie bei "Envelope Tracking", wobei Reserve gelassen wird, damit Amplitudenspitzen nicht durch die Spannung am Ausgang des DC/DC-Konverters begrenzt werden. Der Längsregler unterdrückt störende Anteile im Ausgangssignal des DC/DC-Konverters wie beispielsweise einen Ripple bei der Schaltfrequenz und liefert nötigenfalls auch die höherfrequenten Anteile der Amplitudenmodulation, so dass kein weiterer konventioneller Verstärker benötigt wird. Dabei ist es zweckmäßig, zumindest die Ausgangsspannung des Längsreglers zu regeln, während der DC/DC-Konverter auch gesteuert betrieben werden kann.

Die dritte Möglichkeit besteht darin, beide Verstärker parallel laufen zu lassen und beispielsweise nur bei niedrigeren Leistungen den Schaltverstärker abzuschalten oder zu überbrücken.

Hierbei bietet es sich insbesondere auch an, als konventionellen Verstärker denjenigen Verstärker zu verwenden, der sich ohnehin in der Schaltung zur Verstärkung des höherfrequenten Anteils befindet. Das heißt, es wird bei einer niedrigen Ausgangspannung der Schaltverstärker, welcher den niederfrequenten Anteil verstärkt, abgeschaltet, so dass beide Anteile gemeinsam von dem konventionellen Verstärker verstärkt werden. Etwaige Filter, die den Frequenzgang im Zweig des konventionellen Verstärkers nach unten hin begrenzen, werden gegebenenfalls überbrückt.

Bei einer weiteren Lösung wird der abgeschaltete Schaltverstärker überbrückt, so dass sein Treiber die Ausgangsspannung in diesem Zweig liefert. Nötigenfalls wird die Verstärkung des Treibers dabei angepasst.

Bei einem bevorzugten Ausführungsbeispiel wird die frequenzmäßige Aufteilung zwischen dem niederfrequenten Anteil, welcher von dem Schaltverstärker verstärkt werden soll, und dem höherfrequenten Anteil, welcher von einem konventionellen Verstärker mit großer Bandbreite verstärkt werden soll, in Abhängigkeit von der gewünschten Ausgangsspannung gewählt. Das heißt, es findet kein abruptes Umschalten, sondern ein stufenweiser oder sogar weicher, kontinuierlicher Übergang statt. Insbesondere kann hierbei auch die Schaltfrequenz des Schaltverstärkers variiert werden, vorzugsweise zusammen mit der Eckfrequenz des nachfolgenden Tiefpasses und der Übernahmefrequenz einer vorausgehenden Frequenzweiche.

Ein derartiges Verfahren zur Kombination mindestens zweier Verstärker oder Verstärkermodi, welches einerseits die notwendige Bandbreite gewährleistet und andererseits bei niedriger Ausgangsleistung die durch das Schalten bedingte Verlustleistung des Schaltverstärkers reduziert, ist neben der Verwendung zur Erzeugung eines Amplitudenmodulationssignals mit gutem Wirkungsgrad innerhalb der erfindungsgemäßen Sendeschaltung auch in vielen weiteren Anwendungen sinnvoll. Dieses Verfahren bildet daher einen eigenständigen Erfindungsgedanken.

Der Wirkungsgrad der gesamten Sendeschaltung ist dann besonders attraktiv, wenn auch das Amplitudenmodulationssignal, welches ja die Versorgungsspannung für den Sendeverstärker bildet, seinerseits möglichst verlustarm bereitgestellt werden kann. Die Verwendung eines Schaltverstärkers, der mittels einer Pulsmodulation angesteuert wird, hat den Vorteil, dass am drosselnden Bauelement idealisiert entweder der Strom oder die Spannung und damit auch die Verlustleistung 0 ist. So kann zum Beispiel mit einer Pulsfrequenz- oder Pulsweitenmodulation sowie nachfolgender Tiefpassfilterung mit gutem Wirkungsgrad eine wertkontinuierliche Spannung erzeugt werden. Die übliche Realisierung sieht als Schaltverstärker einen entsprechenden Pulsweitenmodulator mit analogem Eingang vor.

Gerade in Mobilfunkgeräten werden aber sowohl die Winkelinformationen als auch die Amplitudeninformationen in einem DSP erzeugt und liegen somit als digitale Informationen vor. Eine Pulsweitenmodulation mit den herkömmlichen Bauteilen, beispielsweise mittels eines Class-S-Verstärkers gemäß dem Stand der Technik, setzt dabei eine D/A-Umsetzung voraus, die einen zusätzlichen Aufwand mit sich bringt und in der Regel nicht ganz linear ist. Das gleiche gilt, wenn der Regler im Amplitudenzweig digital arbeiten soll, d.h. ein digitaler Vergleich zwischen Soll- und Istwerten durchgeführt werden soll. In allen diesen Fällen besteht die Aufgabe, eine einem digitalen Wert entsprechende Spannung verlustarm bereitzustellen.

Bei einem besonders bevorzugten Ausführungsbeispiel wird daher ein Pulsmodulator verwendet, der ein pulsmoduliertes Signal direkt aus einem Digitalsignal erzeugt, wobei das pulsmodulierte Ausgangssignal dieses Pulsmodulators durch einen nachgeschalteten Filter geglättet wird, um so ein analoges Amplitudenmodulationssignal bzw. einen Teil davon, vorzugsweise den niederfrequenten Anteil, zu erzeugen. Bei dem pulsmodulierten Signal kann es sich z.B. um ein Delta-, Sigma-Delta-, pulsweiten-, pulsfrequenz- oder pulsphasenmoduliertes Signal handeln.

Bei einem besonders bevorzugten Ausführungsbeispiel handelt es sich bei dem pulsmodulierten Signal um ein pulsweiten-oder pulsfrequenzmoduliertes Signal, welches unter Verwendung einer Zählschaltung aus dem Digitalsignal (bzw. einem digitalen Wert) erzeugt wird.

Ein pulsfrequenzmoduliertes Signal kann hierbei beispielsweise mittels einer von einem Digitalsignal angesteuerten Digitalsyntheseschaltung (DDS) erzeugt werden. Eine solche DDS weist üblicherweise einen Akkumulator, d.h. einen getakteten, rückgekoppelten, speichernden Summierer auf, dessen Zählbereich zyklisch durchlaufen wird. Die Zyklusdauer hängt zum einen von der Taktfrequenz, zum anderen von der Größe eines angelegten Summanden, d.h. dem Addierwert oder sogenannten "Frequenzwort", und dem Zählbereich ab. Dieser Akkumulator addiert mit jedem Takt das Frequenzwort bis zu einem Überlauf auf und beginnt dann wieder von vorn. Durch die Rückkoppelung des Ausgangs auf den Eingang des Akkumulators wird automatisch der nach einem Überlauf des Akkumulators auftretende Rest beim nächsten Zyklus mit aufaddiert. Es lassen sich folglich in Abhängigkeit von der Taktfrequenz, der Breite des Akkumulators und des Frequenzworts unterschiedliche Ausgangsfrequenzen erzeugen. Mit dieser Methode kann ein moduliertes Signal erzeugt werden, indem während des Betriebs das digitale Frequenzwort entsprechend gewechselt wird. Bei der Pulsfrequenzmodulation mittels der DDS kann einfach das Überlaufsignal oder das Carry-bit verwendet werden, d.h. es wird ein sogenanntes Puls-Output-DDS-Verfahren benutzt. Diese Zusammenhänge sind allgemein bekannt.

Alternativ zu einem solchen DDS-Verfahren kann auch ein sogenanntes "Fractional-N-Syntheseverfahren" oder ein anderes Frequenzsyntheseverfahren verwendet werden.

Bei einem weiteren bevorzugten Ausführungsbeispiel wird ein pulsweitenmoduliertes Signal unter Verwendung eines von einem Digitalsignal angesteuerten, getakteten Frequenzteilers, beispielsweise einer Flip-Flop-Kette, erzeugt. Durch eine Verknüpfung mehrerer solcher Frequenzteiler mittels logischer Gatter lassen sich unterschiedliche Tastverhältnisse ("Duty-Cycles") erzielen.

Beide Verfahren arbeiten also mit Zählschaltungen. Während bei der Puls-Output-DDS jedoch mit einem die Pulsfrequenz bestimmenden Steuerwort hochgezählt wird, zählt ein Frequenzteiler in Einerschritten.

Die Spannung des gepulsten Signals kann anschließend, beispielsweise unter Verwendung einer Spule, hochtransformiert werden, so dass die Ausgangsspannung größer ist als die Versorgungsspannung des Pulsmodulators.

Je nach Bezugspotential und äußerer Beschaltung kann ein solcher Leistungs-DAC nicht nur positive, sondern auch negative Spannungen abgeben. Sofern eine Masse, eine negative und eine positive Versorgungsspannung zur Verfügung stehen, können beispielsweise jeweils derartige DC/DC-Konverter zwischen die positive Versorgungsspannung und die Masse sowie die negative Versorgungsspannung und die Masse geschaltet werden. Vorteilhaft ist hier, soweit der Ausgangsspannungsbereich der DC/DC-Konverter nicht betragsmäßig nach unten begrenzt ist, jeweils nur einen der beiden DC/DC-Konverter einzuschalten und dadurch die Verlustleistung durch den jeweils anderen DC/DC-Konverter zu vermeiden. Auf diese Weise lassen sich sowohl positive als auch negative Spannungen mit gutem Wirkungsgrad erzeugen. Hierbei ist es außerdem vorteilhaft, Baugruppen wie die Takterzeugung sowie den Tiefpass am Ausgang oder Teile derselben für beide DC/DC-Konverter gemeinsam zu nutzen, so dass im Wesentlichen noch die Schalter getrennt wären. Sofern dies zur Vergrößerung des Frequenzbereichs erforderlich ist, bietet sich auch die Kombination mit einem Operationsverstärker an.

Insbesondere bei Geräten, die mittels mehrerer in Reihe geschalteter Zellen, beispielsweise Batterien, mit Energie versorgt werden, lässt sich durch eine geeignete Anzapfung sowohl eine positive als auch eine negative Versorgungsspannung gewinnen. Der Ruhestrom ist dabei niedrig, denn für Ausgangspannungen gleich 0 wäre das Tastverhältnis des Schaltverstärkers 0, so dass keine Leistung für Schaltvorgänge aufgewendet werden bräuchte. Neben mobilen Endgeräten eignet sich eine solche Schaltung folglich auch beispielsweise für Audioendstufen mit digitaler Ansteuerung, beispielsweise Aktivboxen, die in Anlehnung an dieses Konzept entworfen werden könnten.

Die Anwendung einer solchen Form der D/A-Umsetzung bzw. digital gesteuerten DC/DC-Konvertierung ist nicht auf die Erzeugung der Versorgungsspannung für eine Sendeverstärkereinheit bzw. eines Amplitudenmodulationssignals beschränkt. Ein solcher Schaltmodulator kann auch allgemein als "Leistungs-DAC" mit hohem Wirkungsgrad eingesetzt werden. Er bildet daher ebenfalls eine eigenständige Erfindungsidee auch außerhalb des Rahmens der vorliegenden Erfindung.

Insofern lehrt die vorliegende Erfindung also auch allgemein ein Verfahren zur Verstärkung, bei dem unter Einsatz von Pulsmodulationen aus einer elektrischen Versorgungsspannung eine variable Ausgangsspannung erzeugt wird, wobei die Höhe der Ausgangsspannung bei gegebener Versorgungsspannung durch ein Digitalsignal eingestellt wird.

Für die vorliegende Erfindung bietet dieser Erfindungsgedanke insbesondere den Vorteil, dass eine rein digitale Regelung möglich ist, indem beispielsweise im Rückkopplungszweig für die Amplitude ein ADC eingesetzt wird, so dass das digitale Ist-Signal direkt mit dem digitalen Soll-Signal verglichen werden kann und auf digitaler Ebene ein Abgleich erfolgen kann. In Abhängigkeit vom berechneten Regelfehler kann dann direkt der Pulsmodulator mit dem digitalen Eingang angesteuert werden. Insbesondere in Fällen, in denen eine durch die endliche Rechengeschwindigkeit eventuell entstehende Totzeit tolerierbar ist, können also mit einem solchen digital gesteuerten Schaltmodulator die Vorteile der digitalen Signalverarbeitung auch bei Regelungen genutzt werden. Bei besonders zeitkritischen Verhalten bietet sich solcher digital gesteuerter Schaltmodulator, wie bei den genannten Ausführungsbeispielen, insbesondere zum Steuern oder Regeln eines niederfrequenten Anteils eines Amplitudensignals an, wobei der höherfrequente Anteil in einem herkömmlichen Regelkreis mit einem kontinuierlichen Verstärker geregelt wird und Regelfehler im niederfrequenten Anteil wieder korrigiert.

Die Erfindung wird im Folgenden unter Hinweis auf die beigefügten Zeichnungen anhand von Ausführungsbeispielen näher erläutert. Es wird ausdrücklich darauf hingewiesen, dass die einzelnen Merkmale nicht nur in den beschriebenen Kombinationen, sondern auch einzeln oder in anderen Kombinationen erfindungswesentlich sein können. Insbesondere können alle nur verfahrensmäßig beschriebenen Merkmale auch bezüglich einer entsprechenden Schaltung erfindungswesentlich sein und umgekehrt. In den Figuren werden in den verschiedenen Ausführungsbeispielen verwendete gleichartige Bauteile zur besseren Übersicht mit denselben Bezugsziffern bezeichnet. Es stellen dar:
Figur 1 ein schematisches Blockschaltbild für eine Regelung des Amplitudenmodulationssignals gemäß einem ersten Ausführungsbeispiel der Erfindung,
Figur 2 ein schematisches Blockschaltbild für eine Regelung des Amplitudenmodulationssignals gemäß einem zweiten Ausführungsbeispiel der Erfindung,
Figur 3 ein schematisches Blockschaltbild für eine Regelung des Amplitudenmodulationssignals gemäß einem dritten Ausführungsbeispiel der Erfindung,
Figur 4 ein schematisches Blockschaltbild für eine Schaltung zur Erzeugung eines Amplitudenmodulationssignals mittels eines Leistungspulsmodulators mit digitaler Ansteuerung,
Figur 5 ein schematisches Blockschaltbild einer Verstärkereinrichtung zur Verstärkung des Amplitudenmodulationssignals gemäß einem fünften Ausführungsbeispiel der Erfindung.

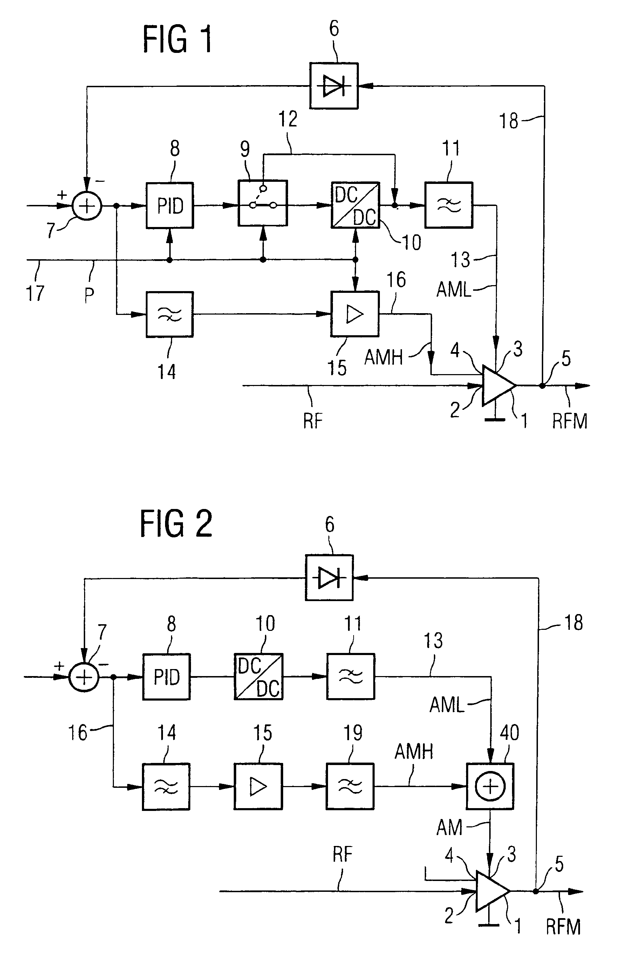

Bei dem Ausführungsbeispiel gemäß Figur 1 wird an einem Eingang 2 eines Sendeverstärkers 1 ein winkelmoduliertes Eingangssignal RF angelegt. Dieses winkelmodulierte Eingangssignal RF weist eine konstante Amplitude auf. An den Versorgungsspannungseingang 3 und den Eingang für die Transistorbasis- bzw. Gatevorspannung 4 des Sendeverstärkers 1 wird außerdem ein Amplitudenmodulationssignal angelegt und auf das winkelmodulierte Eingangssignal RF aufmoduliert. Am Ausgang liegt dann das gewünschte winkel- und amplitudenmodulierte Sendesignal RFM an, welches zur Antenne geleitet wird.

Am Abzweigpunkt 5 wird ein Teil dieses winkel- und amplitudenmodulierten Sendesignals RFM über einen Rückkopplungszweig 18 zu einem Hüllkurvendetektor 6 geleitet. Dessen Ausgangssignal, das die aktuelle Amplitude repräsentiert, wird in einem Subtraktionsglied 7 mit einem ankommenden analogen Amplitudenmodulationssignal verglichen. Das heißt, in diesem Subtraktionsglied 7 findet ein Vergleich vom Istwert, ermittelt mittels des Hüllkurvendetektors 6, und eines eingegebenen Sollwerts AM statt. Die Differenz wird dann zum einen auf einen Regler 8, vorzugsweise einen PID-Regler 8, und zum anderen parallel dazu auf den Eingang eines Hochpasses 14 gelegt. Der Regler 8 weist einen integrierten Filter auf, welcher die Bandbreite und Regelcharakteristik des geschlossenen Regelkreises entscheidend beeinflusst. Über den Regler 8 und den Hochpass 14 wird somit das anliegende Differenzsignal zur Ansteuerung der Sendeendstufe 1 in einen niederfrequenten Anteil und einen höherfrequenten Anteil aufgespalten.

Der niederfrequente Anteil wird im Zweig 13, der höherfrequente Anteil im Zweig 16 geführt. Je nach Wahl der Grenzfrequenz des Reglers 8 und des Hochpasses 14 wird der jeweilige Frequenzbereich festgelegt. Der niederfrequente Anteil wird in einem DC/DC-Konverter 10, hier ein sogenannter Class-S-Verstärker, d.h. ein Schaltverstärker, langsam eingestellt. Die Verstärkung durch diesen DC/DC-Konverter 10 weist einen hohen Wirkungsgrad auf. Die durch die Schaltfrequenz des DC/DC-Konverters 10 und dessen Oberwellen entstehenden Störungen werden durch einen nachfolgenden Tiefpass 11 ausgefiltert, welcher ebenfalls die Bandbreite dieses Regelzweigs 13 nach oben hin begrenzt. Das am Ausgang des Tiefpasses 11 anliegende niederfrequente Signal wird auf den Versorgungsspannungseingang 3 der Sendeendstufe 1 geleitet. Über diesen Regelzweig 13 wird der weitaus größte Teil der Gesamtleistung des Amplitudenmodulationssignals geregelt.

Der höherfrequente Anteil des Amplitudenmodulationssignals bzw. des am Ausgang des Subtraktionsglieds 7 anliegenden Differenzsignals wird in einem konventionellen, möglichst breitbandigen Verstärker 15 verstärkt und über den Zweig 16 an den Eingang 4 für die Transistorbasis- oder Gatevorspannung der Sendeendstufe 1 gelegt. Auf diese Weise werden die durch die Bandbegrenzung im Regelzweig 13 für den niederfrequenteren Anteil AML des Amplitudenmodulationssignals AM entstehenden Modulationsfehler mit geringer Leistung über den höherfrequenteren Anteil AMH ausgeregelt.

Da bei geringer Leistung der DC/DC-Konverter 10 nicht mehr effizient arbeitet, wird er bei geringer mittlerer Sendeleistung ausgeschaltet und überbrückt. Hierzu dienen der Schalter 9 und die Brücke 12. Der Schalter 9 wird ebenso wie das Ein-und Ausschalten des DC/DC-Konverters 10 über eine Steuerleitung 17 durchgeführt, auf der ein Pegelsignal P, welches die Höhe des Sendeleistungspegels bestimmt, angelegt wird. Bei abgeschaltetem und überbrücktem DC/DC-Konverter 10 muss der Regler 8 in der Lage sein, allein den benötigten geringen Strom zu liefern. Falls der nun abgeschaltete und überbrückte DC/DC-Konverter 10 eine Verstärkung ungleich eins hatte, wird die Verstärkung des Reglers 8 entsprechend angepasst.

Da die Kennlinie des Sendeverstärkers 1 bei dem benötigten relativ großen Regelbereich im allgemeinen keine konstante Steilheit aufweist, wird bei dem dargestellten Ausführungsbeispiel die gesamte Regelverstärkung dadurch konstant gehalten, dass die Verstärkung des Reglers 8 und gegebenenfalls auch die Verstärkung des kontinuierlich arbeitenden Verstärkers 15 im Zweig 16 des höherfrequenten Anteils AMH des Amplitudenmodulationssignals AM in Abhängigkeit vom Sendeleistungspegel und somit in Abhängigkeit von der Steilheit des Sendeverstärkers im jeweiligen Bereich eingestellt wird. Steilheitsänderungen der Kennlinie des Sendeverstärkers aufgrund von Veränderungen des Sendeleistungspegels werden dabei folglich durch die einstellbare Regelverstärkung des Reglers 8 und des Verstärkers 15 ausgeglichen. Diese Einstellung erfolgt ebenfalls mittels des Pegelsignals P über die Leitung 17.

Figur 2 zeigt einen recht ähnlichen, aber vereinfachten Aufbau. Bei diesem Ausführungsbeispiel werden der niederfrequentere Anteil AML und der höherfrequente Anteil AMH des Amplitudenmodulationssignals AM in einem Addierer 40 zusammengeführt und als gemeinsames Signal auf den Versorgungsspannungseingang 3 des Sendeverstärkers 1 gelegt. Der Eingang 4 des Sendeverstärkers 1 für die Transistorbasis- oder Gatevorspannung wird beispielsweise auf ein konstantes Potential gelegt. Abweichend von dem Ausführungsbeispiel gemäß Figur 1 ist hier der DC/DC-Konverter 10 nicht ausschaltbar und auch nicht überbrückbar. Ebenso kann die Regelcharakteristik des Reglers 8 und des linearen Verstärkers 15 nicht variiert werden. Außerdem ist hinter dem linearen Verstärker 15 im Zweig 16 ein Tiefpass 19 eingebaut, welcher unerwünschte Oberschwingungen, die in dem Verstärker 15 entstehen können, eliminiert. Bei diesem Beispiel wird also die Versorgungsspannung für den Sendeverstärker 1 zusammengesetzt aus einer langsam über den DC/DC-Konverter 10 gewonnenen Spannung und einer über einen breitbandigen linearen Regelverstärker 15 erzeugten Spannung, die die durch die Bandbegrenzung im DC/DC-Konverter 10 bzw. dem nachfolgenden Tiefpass 11 entstehenden Modulationsfehler ausregelt.

Bei einem weiteren, nicht dargestellten Ausführungsbeispiel handelt es sich bei dem niederfrequenten Anteil des Amplitudenmodulationssignals um die mittlere Sendeleistung (d.h. den reinen Gleichspannungsanteil), die über die Versorgungsspannung mittels des DC/DC-Konverters eingestellt wird, d.h. ohne eine weitere Regelung gesteuert wird. Eine Regelung findet nur während des Einstellens statt, wobei sich zum Einstellen dieser mittleren Sendeleistung besonders gut Abschnitte mit bekannter Leistung, beispielsweise Tailbits-, Trainingsbits-und Synchronisationssequenzen eignen. Da eine solche langsame Einstellung der mittleren Sendeleistung über die Versorgungsspannung nicht exakt ist und Veränderungen nicht schnell genug folgen kann, werden durch eine schnelle Nachregelung über einen permanenten Regelkreis langsame Abweichungen kompensiert. Hierzu muss die Schaltung gemäß Figur 2 lediglich so verändert werden, dass der Rückkopplungszweig 18 im allgemeinen nur zusammen mit dem Zweig 16 einen Regelkreis bildet und nur zeitweise auch so geschaltet werden kann, dass der Zweig 13 von dem Regelkreis mit umfasst ist, um so vorübergehend die Einstellung der mittleren Versorgungsspannung vorzunehmen.

Bei einem weiteren, nicht dargestellten Ausführungsbeispiel wird die mittlere Versorgungsspannung dadurch gewonnen, dass mehrere feste Spannungen mit einem guten Wirkungsgrad entweder durch mehrere Schaltregler oder durch einen Schaltregler mit mehreren Ausgängen gewonnen werden. Alternativ können die festen Spannungen auch aus einer aus mehreren Zellen bestehenden Spannungsversorgung durch mindestens eine Zwischenanzapfung erzeugt werden. Beispiele für eine Spannungsversorgung aus Zellen sind Batterien, Akkumulatoren, Solar- und Brennstoffzellen. Bei Batterien und Akkus ist es insbesondere von Vorteil, wenn die Möglichkeit besteht, durch elektrisches Umverschalten die Positionen so zu tauschen, dass die einzelnen Zellen im zeitlichen Mittel gleichmäßig entladen werden. Es bietet sich an, Zellen oder ZelLenpakete mit binär gestuften Spannungswerten, beispielsweise mit 1 V, 2 V, 4 V, 8 V zu verwenden. Eine Feinregelung kann dabei mit einem linear arbeitenden Differenzregler (Längsregler) erfolgen, wodurch der hohe Gesamtwirkungsgrad nicht nennenswert verschlechtert wird. Da der Längsregler die Spannung nicht anheben, sondern nur absenken kann, muss die der mittleren Versorgungsspannung entsprechend eingestellte Eingangsspannung des Längsreglers um eine ausreichende Reserve höher sein als die mittlere Versorgungsspannung, damit Amplitudenspitzen nicht unzulässig abgeschnitten werden.

Wenn nicht die Spannung aller Zellen benötigt wird, können auch Zellen zeitweise parallel geschaltet werden. Dabei ergibt sich eine gleichmäßigere Entladung der Zellen, als wenn einzelne Zellen aus dem Stromkreis herausgenommen werden.

Die Konzepte zur Spannungsversorgung von Sendeverstärkern sind auch unabhängig von EER zur Spannungsversorgung von Sendeverstärkern, beispielsweise in Anlehnung an "Envelope Tracking" oder bei Modulationen mit konstanter Hüllkurve, und darüber hinaus nützlich und bilden daher einen eigenständigen Erfindungsgedanken.

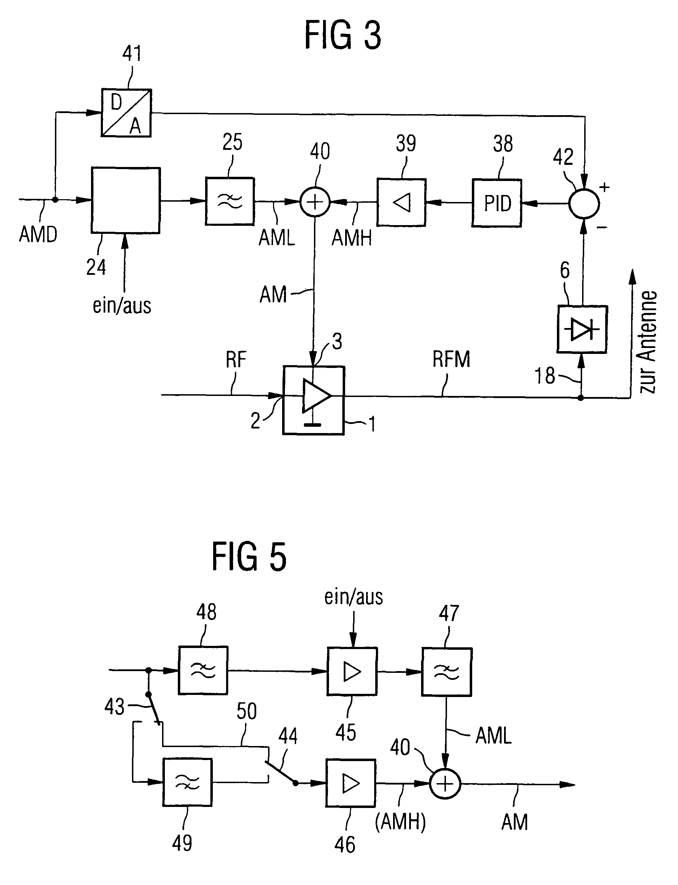

Ein ähnliches Ausführungsbeispiel ist in Figur 3 gezeigt. Hierbei wird ein digitaler Sollwert für die Hüllkurve, d.h. ein digitales Amplitudenmodulationssignal AMD vorgegeben. Dieses digitale Amplitudenmodulationssignal AMD wird mittels eines Pulsweitenmodulators 24 in einen analogen Wert umgesetzt. Ein solcher Pulsweitenmodulators 24 weist im Mittel einen guten Wirkungsgrad auf. Das Ausgangssignal dieses Pulsweitenmodulators 24 wird durch einen Tiefpass 25 von störenden Frequenzanteilen, wie sie etwa durch die Schaltfrequenz bedingt sind, befreit. Wegen des Tiefpasses 25 erreicht der Pulsweitenmodulator 24 jedoch nicht die benötigte Bandbreite. Daher wird das digital vorliegende Amplitudenmodulationssignal AMD zusätzlich zu einem Digital-Analog-Konverter 41 geleitet. Hierbei handelt es sich um einen Standard-DAC 41 mit niedriger Ausgangsleistung. In ihm ist ein Tiefpass mit sehr hoher Eckfrequenz als Rekonstruktionsfilter eingebaut, so dass keine Treppenstufen, sondern ein geglättetes Signal ausgegeben wird. Die Bandbreite des Standard-DACs 41 ist so gewählt, dass das Amplitudenmodulationssignal ohne Verzerrungen übermittelt wird. Das Ausgangssignal dieses zum Pulsweitenmodulator 24 parallel geschalteten DACs 41 mündet als Soll-Signal in eine Regelschleife. Das Soll-Signal wird mit einem mittels eines Hüllkurvendetektors 6 über den Rückkopplungszweig 18 ermittelten Ist-Signal der aktuellen Amplitude des Sendesignals RFM verglichen. Hierzu dient ein Subtraktionsglied 42. Das Differenzsignal, welches dem Fehler in der Sendeamplitude entspricht, wird mit einem Regler 38, vorzugsweise einem PID-Regler, welcher proportional, integrierend und differenzierend wirkt, bewertet und mit einem Verstärker 39 mit kleiner Leistung verstärkt. Dieser Verstärker 39 verursacht lediglich eine geringe Verlustleistung, seine Leistung genügt bei großer Sendeamplitude nur, um Fehler auszuregeln und hohe Frequenzen zu ergänzen, während der Hauptanteil der Versorgungsspannung für die Sendeendstufe 1 vom Pulsweitenmodulator 24 kommt.

Bei sehr niedriger Sendeamplitude kann dieser kleine Verstärker 39 aber den Sendeverstärker 1 allein versorgen. Der Pulsweitenmodulator 24 wird dann abgeschaltet. Damit entfällt auch die Verlustleistung, die zum hochfrequenten Schalten der Versorgungsspannung nötig ist, beispielsweise für das Umladen von Gate-Kapazitäten von FETs im Pulsmodulator 24. Die Koeffizienten des PID-Reglers 38 werden dann vorzugsweise der neuen Übertragungsfunktion des Regelkreises angepasst.

Insbesondere dann, wenn der Tiefpassfilter 25 hinter dem Pulsweitenmodulator 24 eine einstellbare Bandbreite hat und die Koeffizienten des PID-Reglers 38 ausreichend nachgeführt werden können, kann auch die Schaltfrequenz des Pulsweitenmodulators 24 der Sendeamplitude oder deren zeitlichen Mittelwert, beispielsweise gegeben durch den Sendeleistungspegel, angepasst werden. Auf diese Weise wird der Pulsweitenmodulator 24 nicht hart zu- und weggeschaltet, sondern die frequenzmäßige Aufteilung verschiebt sich je nach Ausgangsleistung. Bei geringer Ausgangsleistung ist dadurch die Schaltfrequenz gering, damit möglichst wenig Verlustleistung durch das Schalten erzeugt wird. Bei großer Ausgangsleistung fällt dagegen eine größere Verlustleistung durch eine hohe Schaltfrequenz kaum ins Gewicht. Die Schaltfrequenz und die Grenzfrequenz der nachfolgenden Filterung im Tiefpass 25 werden so hoch gewählt, dass der Verstärker 39 mit der geringen Leistung nicht durch die Anteile in den höheren Frequenzen überfordert wird und dass sich ein guter Gesamtwirkungsgrad ergibt. Wenn möglich werden auch die Koeffizienten des PID-Reglers entsprechend an die Eckfrequenz des Tiefpasses 25 angepasst. Ein solcher Übergang kann nicht nur kontinuierlich, sondern auch in Stufen erfolgen, wobei als Kriterium nicht nur die momentane Sendeamplitude, sondern beispielsweise auch ein eingestellter Sendeleistungspegel oder ein kurzzeitiger Mittelwert in Frage kommen.

Die digitalen Ansteuersignale für den Pulsweitenmodulator 24 und den Standard-DAC 41 können auch unterschiedlich sein. So können sie beispielsweise unterschiedlich skaliert sein, einen unterschiedlichen Frequenzgang aufweisen, mit einem differentiellen Zeitversatz versehen werden oder unterschiedlich nichtlinear vorverzerrt werden, um so beispielsweise Nichtlinearitäten in der Kennlinie des Sendeverstärkers 1 auszugleichen.

Anstelle des Pulsweitenmodulators 24 kann auch ein anderer Pulsmodulator, beispielsweise ein Pulsfrequenzmodulator, gewählt werden. Ebenso kann hier auch eine andere digital ansteuerbare Spannungsquelle, beispielsweise die oben genannte Kombination aus mehreren DC/DC-Konvertern oder entsprechend anzapfbare Batterien bzw. Akkumulatoren mit mehreren Zellen verwendet werden.

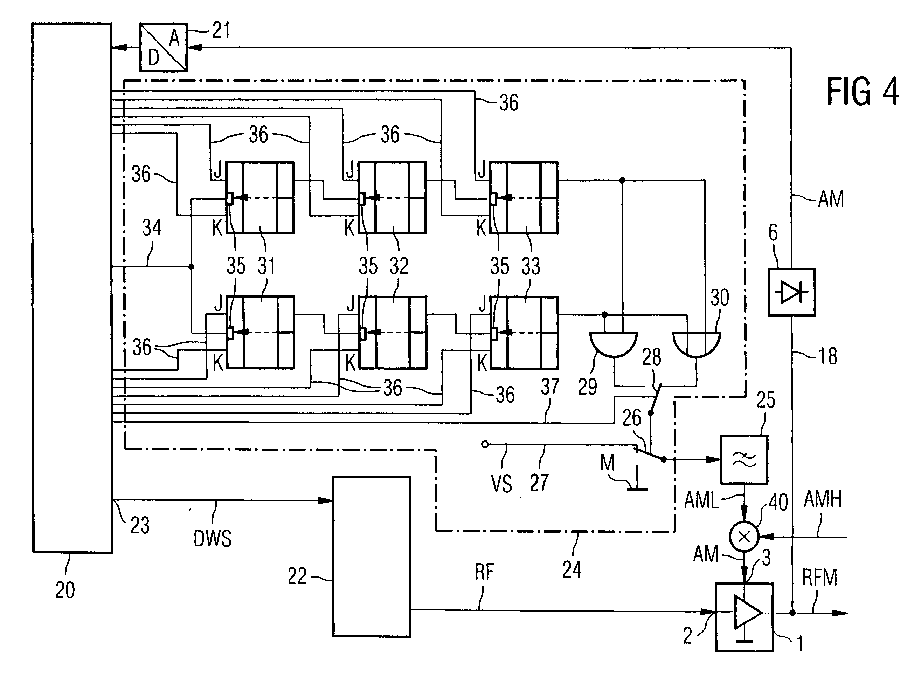

Figur 4 zeigt einen schematischen Schaltplan für ein konkreteres Ausführungsbeispiel eines geeigneten Pulsweitenmodulators. Hierbei ist der Pulsweitenmodulator 24 durch zwei Frequenzteiler aufgebaut, die aus jeweils drei zu Ketten zusammengeschalteten JK-Flip-Flops 31, 32, 33 bestehen. Bei diesen Frequenzteilern handelt es sich folglich um Zählschaltungen, wobei das jeweils vorderste Flip-Flop 31, an dem die Taktleitung 34 anliegt, als LSB (Least Significant Bit) fungiert und das in der Kette letzte Flip-Flop 33 bzw. dessen Ausgang das MSB (Most Significant Bit) der Zählschaltung angibt. Werden die MSB an den Ausgängen von zwei parallel betriebenen, gleich langen Frequenzteilerketten miteinander logisch verknüpft, lässt sich dadurch die Pulsbreite des Ausgangssignals durch den Unterschied der Initialisierungswerte der Zähler einstellen. Für Duty-Cycles > 0,5 können die beiden Ausgänge logisch mittels eines Oder-Gatters 30 verknüpft werden, kleinere Duty-Cycles lassen sich mit einem Und-Gatter 29 erzielen. Die Pulsbreite lässt sich sowohl symmetrisch als auch unsymmetrisch vergrößern, je nachdem, ob beide Zählerinhalte oder nur ein Zählerinhalt verändert wird.

Im vorliegenden Fall werden zum Erzeugen eines pulsweitenmodulierten Signals die Flip-Flops 31, 32, 33 zuerst über die Leitungen 36 und die Eingänge J und K von einer Logik, in diesem Beispiel vom DSP 20, mit einem passenden Offset initialisiert und der Schalter 28 vom DSP 20 aus über die Leitung 37 auf das Und-Gatter 29 oder das Oder-Gatter 30 geschaltet. Bei dem DSP 20 kann es sich um einen üblichen digitalen Signalprozessor handeln, wie er z.B. in Mobilfunkgeräten verwendet wird. Gegebenenfalls weist dieser DSP auch zusätzliche Ein- und Ausgänge mit integrierten ADCs oder DACs auf, um zusätzliche Parameter empfangen oder ausgeben zu können, und er ist entsprechend zur Durchführung des erfindungsgemäßen Verfahrens in geeigneter Weise programmiert. Der DSP ist lediglich der Einfachheit halber in Form eines einzelnen Blocks 20 dargestellt. Er kann auch aus mehreren geeignet zusammengeschalteten Komponenten bestehen.
Dann wird jeweils über die Leitungen 36 eine 1 an den J- und K-Eingängen angelegt, so dass die Ketten bei anliegendem Takt über die Leitung 34 am Takteingang 35 des jeweils ersten Flip-Flops 31 als Frequenzteiler arbeiten. In dem vorliegenden Beispiel kann mit den drei Flip-Flops 31, 32, 33 in jeder der Ketten eine Auflösung von 3 Bit erzielt werden. Das vom Und-Gatter 29 oder vom Oder-Gatter 30 abgegriffene Signal steuert wiederum einen beispielsweise mit einem FET aufgebauten Schalter 26, der im Rhythmus des pulsweitenmodulierten Signals eine Versorgungsspannung VS, welche an dem einen Eingang 27 des Schalters 26 anliegt, auf einen Tiefpassfilter 25 weiterleitet. Dieser Tiefpassfilter 25 glättet die Spannung und erzeugt so die gewünschte analoge Spannung bzw. im vorliegenden Fall den niederfrequenten Anteil des amplitudenmodulierten Signals, welches den Sendeverstärker versorgt.

Optional kann der Eingang des Tiefpasses 25 auf eine Masse M geschaltet werden, wenn er nicht mit der Spannungsversorgung 27 verbunden ist. In diesem Fall ist die Impedanz am Eingang des Tiefpassfilters 25 stets niedrig. Wenn der Eingang des Tiefpassfilters 25 stattdessen offen gelassen würde, geht zwar unter Umständen weniger Leistung verloren, aber der Zusammenhang zwischen Pulsweite und analoger Ausgangsspannung ist im allgemeinen lastabhängig und nicht mehr proportional. Dadurch wäre dann ein Einsatz einer Tabelle im Digitalteil notwendig, um einen dadurch entstehenden Fehler auszugleichen. Eine alternative Lösung anstelle einer Schaltung auf Masse kann je nach Tiefpassschaltung darin bestehen, eine Diode vom Eingang des Tiefpasses so gepolt mit der Masse fest zu verbinden, dass sie bei einem auf die Spannungsversorgung geschalteten Schalter sperrt.

Eine Pulsweitenmodulation ist im Prinzip auch mit einer einzigen Flip-Flop-Kette möglich. In diesem Fall muss dann ein digitaler Vergleicher verwendet werden, der ober- oder unterhalb eines bestimmten Zählerinhalts ein Flag setzt oder löscht. Wenn der Vergleicher nicht "größer" oder "kleiner", sondern nur Gleichheit von zwei Signalen erkennt, kann mit ihm ein Flip-Flop gesetzt werden, das in Abhängigkeit eines bestimmten Zählerstands oder einer bestimmten Zählerstelle, insbesondere des MSBs, wieder gelöscht wird. Der Flip-Flop-Ausgang lässt sich so in Abhängigkeit des Vergleichswerts pulsweitenmodulieren.

In dem in der Figur 4 dargestellten Ausführungsbeispiel wird das vom Pulsmodulator 24 über den Tiefpass 25 zur Verfügung gestellte niederfrequente Amplitudenmodulationssignal AML in einem Addierer 40 mit einem hochfrequenten Anteil AMH des Amplitudenmodulationssignals AM kombiniert und auf den Versorgungsspannungseingang 3 der Endstufe 1 gegeben. Der hochfrequente Anteil AMH des Amplitudenmodulationssignals AM lässt sich beispielsweise wie bei dem Ausführungsbeispiel gemäß Figur 3 erzeugen. Eine Regelung erfolgt dadurch, dass wie in den anderen Ausführungsbeispielen über einen Rückkopplungszweig 18 und einen Hüllkurvendetektor 6 die aktuelle Amplitude zurückübermittelt wird.
In dem in Figur 4 dargestellten Ausführungsbeispiel wird das analoge aktuelle Amplitudensignal einem A/D-Wandler 21 zugeführt und in einen digitalen Wert umgesetzt. Dieses digitale Signal wird dem DSP 20 zugeführt.

In diesem DSP 20 findet die digitale Basisband-Signalverarbeitung statt, d.h. der DSP stellt auch die digitalen Steuersignale über die Leitungen 36 für die Zählerketten des Pulsmodulators 24 zur Verfügung. Es ist dann eine vollkommen digitale Regelung möglich, wobei wenn nötig der digitale Sollwert auch, wie in dem Ausführungsbeispiel gemäß Figur 3, über einen D/A-Wandler umgewandelt werden kann und zu einer schnellen Korrektur durch Vergleich mit einem abgezweigten analogen, aktuellen Amplitudensignal genutzt werden kann.

Im DSP 20 wird bei einer Änderung der Pulsweite im laufenden Betrieb ein günstiger Zeitpunkt ausgewählt, um über die Leitungen 36 zu den Eingängen J und K der Flip-Flops den Wert zumindest eines Teils der Flip-Flops gezielt zu verändern.

Da in dem vorliegenden Ausführungsbeispiel der DSP 20 die komplette Basisband-Signalverarbeitung durchführt, liegt hier im Übrigen auch der Wert für die aktuelle Winkelmodulation an. Dieses digitale Winkelmodulationssignal DWS wird über die Leitung 23 auf eine geeignete Schaltung 22 (hier nur als Block dargestellt) geleitet, welche aus dem digitalen Winkelmodulationssignal DWS ein geeignetes Winkelmodulationssignal RF mit konstanter Amplitude erzeugt, welches wiederum auf den Eingang 2 des Sendeverstärkers 1 gegeben wird. Neben der Auskopplung über den Rückkopplungszweig 18 des amplitudenmodulierten Anteils des amplituden- und winkelmodulierten Sendesignals RFM zur Regelung des Amplitudenmodulationssignals kann selbstverständlich auch, beispielsweise über einen Begrenzer, der winkelmodulierte Anteil des Sendesignals RFM gewonnen werden und zur Schaltung 22 zu Regelungszwecken zurückgeführt werden (nicht dargestellt).

Figur 5 zeigt einen Ausschnitt aus einem weiteren Ausführungsbeispiel zur Verstärkung eines Amplitudenmodulationssignals, ähnlich wie bei dem Ausführungsbeispiel gemäß Figur 2. Bei diesem Ausführungsbeispiel wird das Eingangssignal auf einer Strecke durch einen Tiefpass 48, anschließend durch einen ein-/ausschaltbaren Class-S-Verstärker 45 und durch einen nachgeschalteten weiteren Tiefpass 47 zu einem Addierer 40 geleitet. Ein anderer Teil des Ausgangssignals wird über zwei Schalter 43, 44 und - je nach Schalterstellung der beiden Schalter 43, 44 - über einen Hochpass 49 oder über eine Überbrückungsleitung 50 zu einem Breitbandverstärker 46 mit niedriger Leistung geleitet, dessen Ausgang wiederum auf den Addierer 40 geht. Am Ausgang des Addierers 40 liegt dann das gewünschte Amplitudenmodulationssignal AM an.

Wenn eine hohe Ausgangsleistung des Amplitudenmodulationssignals AM gefordert ist, fällt der durch das Schalten bedingte Sockel im Leistungsverbrauch des Class-S-Verstärkers 45 kaum ins Gewicht. Bei einer hohen Ausgangsleistung, d.h. bei hoher momentaner Amplitude, ist daher der Class-S-Verstärker 45 eingeschaltet und die Schalter 43, 44 befinden sich in der nicht dargestellten Stellung. In diesem Zustand wird durch den Tiefpass 48 und durch den Hochpass 49, die als Frequenzweiche fungieren, das ankommende Signal, hier beispielsweise das von einem Subtraktionsglied 7 wie in Figur 2 kommende Differenzsignal zwischen Amplituden-Sollsignal und Istsignal, in einen niederfrequenten Anteil inklusive Gleichspannungsanteil und in einen hochfrequenten Anteil aufgespalten. Der niederfrequente Anteil wird dann von dem Class-S-Verstärker 45 verstärkt. Der Tiefpass 47 am Ausgang des Class-S-Verstärkers 45 sorgt wiederum für die Unterdrückung der insbesondere durch das Schalten erzeugten Störfrequenzen. Die hochfrequenten Anteile, von denen anzunehmen ist, dass sie nur wenig Leistung enthalten, werden von dem breitbandigen Verstärker 46 mit dem nur bescheidenen Wirkungsgrad verstärkt. Die Verlustleistung ist dabei jedoch - absolut gesehen - nur gering, weil dieser Breitbandverstärker 46 nur die geringen Leistungen verstärken muss. Durch den Einsatz des Class-S-Verstärkers 45 wird das Gesamtsignal auch bei hohen Leistungen mit gutem Wirkungsgrad verstärkt.

Durch das Addieren im Addierer 40 ergibt sich dabei insgesamt ein ausreichend linearer Frequenzgang.

Wenn nur eine geringe Amplitude, d.h. eine niedrige Ausgangsleistung gewünscht wird, würde jedoch der Verlustleistungssockel des Class-S-Verstärkers 45 zu einem insgesamt sehr schlechten Wirkungsgrad führen. In diesem Fall wird der Class-S-Verstärker 45 ausgeschaltet, und der Hochpass 49 vor dem Breitbandverstärker 46 wird durch die Schalter 43, 44 und die Brückenleitung 50 überbrückt. Der Breitbandverstärker 46 übernimmt dann das schwache Signal in seiner vollen Bandbreite.

Alternativ kann auch ein weicherer Übergang erzeugt werden, indem der Class-S-Verstärker 45 nicht abgeschaltet wird, sondern stattdessen die Schaltfrequenz und die Bandbreite des nachfolgenden Tiefpasses 47 abgesenkt wird und gleichzeitig die Eckfrequenzen des Hochpasses 49 und des Tiefpasses 48 an den Eingängen der beiden Verstärker 45, 46 verringert werden.

Bei einem weiteren, nicht dargestellten Ausführungsbeispiel werden die Frequenzweichen digital realisiert. Hierzu werden zwischen die Frequenzweiche und die Verstärker DACs geschaltet oder die Verstärker werden als DACs entsprechend der Leistung, beispielsweise gemäß dem Ausführungsbeispiel 4, ausgeführt. Wie bereits oben zu Figur 4 beschrieben, sieht ein Ausführungsbeispiel auch vor, in einem Zweig, beispielsweise dem Zweig für den überwiegend hochfrequenten Anteil, einen Verstärker mit analogem Eingang und einen vorgeschalteten DAC zu verwenden und im anderen Zweig für den niederfrequenten Anteil einen DAC mit entsprechend hoher Ausgangsleistung einzusetzen.

### Liste der verwendeten Abkürzungen:

- ADC: Analog/Digital-Konverter
- AM: Amplitudenmodulation
- DC: Direct Current (Gleichstrom)
- DDS: Direct Digital Synthesis (Digitalsyntheseschaltung)
- DSP: Digitaler Signalprozessor
- DAC: Digital/Analog-Konverter
- EER: Envelope Elimination and Restoration
- FET: Feldeffekttransisitor
- LSB: Least Significant Bit
- MSB: Most Significant Bit
- PID: proportional, integrierend und differenzierend wir-kender Regler
- PM: Phasenmodulation

## Patentansprüche

1. Verfahren zur Erzeugung eines amplituden- und winkelmodulierten Sendesignals (RFM), bei dem ein winkelmoduliertes Eingangssignal (RF) an einen ersten Eingang (2) eines Sendeverstärkers (1) angelegt wird und ein Amplitudenmodulationssignal (AM) an zumindest einen zweiten Eingang (3,4) des Sendeverstärkers (1) angelegt wird und die Amplitude dabei im Sendeverstärker (1) auf das Eingangssignal (RF) aufmoduliert wird, wobei das Amplitudenmodulationssignal (AM, AMD) in einen niederfrequenten Anteil (AML) und einen höherfrequenten Anteil (AMH) aufgeteilt bearbeitet wird und die beiden Anteile (AML, AMH) des Amplitudenmodulationssignals (AM) vor dem zweiten Eingang (3) des Sendeverstärkers (1) oder über verschiedene Eingänge (3,4) des Sendeverstärkers (1) im Sendeverstärker (1) zusammengeführt werden und dabei zumindest einer der beiden Anteile (AML, AMH) geregelt wird,
**dadurch gekennzeichnet, dass** zumindest ein Anteil (AML) des Amplitudenmodulationssignals (AM) unter Verwendung eines pulsmodulierten Signals aus einer Versorgungsspannung (VS) erzeugt wird, wobei das pulsmodulierte Signal (PM) aus einem Digitalsignal erzeugt wird.

2. Verfahren nach Anspruch 1, **dadurch gekennzeichnet, dass** beide Anteile (AML, AMH) geregelt werden.

3. Verfahren nach Anspruch 1, **dadurch gekennzeichnet, dass** einer der beiden Anteile (AMH) geregelt und der andere Anteil (AML) zumindest zeitweise gesteuert wird.

4. Verfahren nach Anspruch 3, **dadurch gekennzeichnet, dass** der niederfrequente Anteil (AML) zumindest zeitweise gesteuert wird.

5. Verfahren nach einem der Ansprüche 1 bis 4, **dadurch gekennzeichnet, dass** der höherfrequente Anteil (AMH) mittels eines kontinuierlich arbeitenden Regelverstärkers (15, 39, 46) geregelt wird.

6. Verfahren nach einem der Ansprüche 1 bis 5, **dadurch gekennzeichnet, dass** der niederfrequente Anteil (AML) mit Hilfe eines Schaltverstärkers (10, 45) oder Pulsmodulators (24) eingestellt wird.

7. Verfahren nach einem der Ansprüche 1 bis 5, **dadurch gekennzeichnet, dass** der niederfrequente Anteil einer mittleren Versorgungsspannung des Sendeverstärkers entspricht und dass die mittleren Versorgungsspannung mittels mehrerer Schaltverstärker oder mittels eines Schaltverstärkers mit mehreren Ausgängen oder unter Verwendung einer mehrere Zellen aufweisenden Spannungsquelle mit Zwischenanzapfung eingestellt wird.

8. Verfahren nach Anspruch 6 oder 7, **dadurch gekennzeichnet, dass** der niederfrequente Anteil des Amplitudenmodulationssignals mittels eines Verstärkers eingestellt wird, der in Abhängigkeit von der Ausgangsleistung in verschiedenen Betriebsarten betrieben wird, oder welcher unterschiedlich große Transistoren aufweist, die je nach Betriebsart in unterschiedlicher Kombination aktiv oder inaktiv sind, oder dass der niederfrequente Anteil des Amplitudenmodulationssignals mittels einer Verstärkereinheit eingestellt wird, welche eine Kombination von Verstärkern mit verschiedenen Betriebsarten umfasst, wobei eine erste Betriebsart eine Schaltverstärkung umfasst und eine zweite Betriebsart eine kontinuierliche Verstärkung umfasst, und/oder dass in einem Betriebszustand der höherfrequente Anteil (AMH) oder in einem anderen Betriebszustand das gesamte Amplitudenmodulationssignal (AM) durch einen Längsregler der Versorgungsspannung (3) des Sendeverstärkers (1) aufgeprägt wird, wobei der Längsregler einem Schaltverstärker (10, 45) oder einem Pulsmodulator (24) oder einer Überbrückung dieser Bauteile nachgeschaltet ist.

9. Verfahren nach einem der Ansprüche 6 bis 8, **dadurch gekennzeichnet, dass** der oder die Schaltverstärker (10, 45) oder der Pulsmodulator (24) für den niederfrequenten Anteil (AML) des Amplitudenmodulationssignals (AM) bei einer nur geringen benötigten Gesamtleistung des Amplitudenmodulationssignals (AM) abgeschaltet und/oder überbrückt wird/werden oder eine Schaltfrequenz des Schaltverstärkers (10, 45) oder Pulsmodulators (24) gegenüber einer bei hoher benötigter Leistung verwendeten Schaltfrequenz abgesenkt wird.

10. Verfahren nach einem der Ansprüche 1 bis 9, **dadurch gekennzeichnet, dass** der niederfrequente Anteil (AML) an einen Versorgungsspannungseingang (3) des Sendeverstärkers (1) angelegt wird.

11. Verfahren nach einem der Ansprüche 1 bis 10, **dadurch gekennzeichnet, dass** der höherfrequente Anteil (AMH) an einen Versorgungsspannungseingang (3) oder einen Vorspannungseingang (4) des Sendeverstärkers (1) angelegt wird.

12. Verfahren nach einem der Ansprüche 1 bis 11, **dadurch gekennzeichnet, dass** bei der Regelung des nieder-und/oder höherfrequenten Anteils (AML, AMH) eine Nichtlinearität in einer Verstärkungskennlinie des Sendeverstärkers (1) in Abhängigkeit von einem Sendeleistungspegel bereichsweise korrigiert wird.

13. Verfahren nach Anspruch 1, **dadurch gekennzeichnet, dass** das pulsmodulierte Signal (PM) ein pulsweiten- oder pulsfrequenzmoduliertes Signal umfasst, welches unter Verwendung einer Zählschaltung (29, 30, 31, 32, 33, 34, 35, 36) aus dem Digitalsignal erzeugt wird.

14. Verfahren nach Anspruch 13 , **dadurch gekennzeichnet, dass** das pulsfrequenzmodulierte Signal mittels einer von einem Digitalsignal angesteuerten DigitalsyntheseSchaltung erzeugt wird.

15. Verfahren nach Anspruch 13, **dadurch gekennzeichnet, dass** das pulsweitenmodulierte Signal (PM) unter Verwendung eines von einem Digitalsignal angesteuerten, getakteten Frequenzteilers (31, 32, 33, 34, 35, 36) erzeugt wird.

16. Verfahren nach Anspruch 15, **dadurch gekennzeichnet, dass** die Ausgangssignale mehrerer Frequenzteiler (31, 32, 33, 34, 35, 36) logisch untereinander zu einem pulsweitenmodulierten Signal (PM) verknüpft werden.

17. Verfahren nach einem der Ansprüche 1 bis 16, **dadurch gekennzeichnet, dass** die Regelung eines Anteils (AML) des Amplitudenmodulationssignals (AM) durch einen digitalen Vergleich von Ist- und Sollwerten erfolgt.

18. Sendeschaltung zur Erzeugung eines amplituden- und winkelmodulierten Sendesignals (RFM) mit
einem Sendeverstärker (1),
Mitteln (22) zur Erzeugung eines winkelmodulierten Eingangssignals (RF), welche derart aufgebaut und/oder angeordnet sind, dass das winkelmodulierte Eingangssignal (RF) an einem ersten Eingang (2) des Sendeverstärkers (1) anliegt,
und Mitteln zur Erzeugung eines Amplitudenmodulationssignals (AM), welche derart aufgebaut und/oder angeordnet sind, dass das Amplitudenmodulationssignal (AM) an zumindest einem zweiten Eingang (3) des Sendeverstärkers (1) anliegt und dabei die Amplitude im Sendeverstärker (1) auf das Eingangssignal (RF) aufmoduliert wird,
Mittel zur getrennten Bearbeitung des Amplitudenmodulationssignals (AM) in einem niederfrequenten Anteil (AML) und einem höherfrequenten Anteil (AMH),
Mittel (40) zum Zusammenführen der beiden Anteile (AMH, AML) des Amplitudenmodulationssignals (AM) vor dem zweiten Eingang (3) des Sendeverstärkers (1) oder
Mittel zum Zusammenführen der beiden Anteile (AMH, AML) des Amplitudenmodulationssignals (AM) im Sendeverstärker (1) über verschiedene Eingänge (3, 4) des Sendeverstärkers (1),
und Mittel zum Regeln zumindest eines der beiden Anteile (AMH, AML) des Amplitudenmodulationssignals (AM),
**gekennzeichnet durch**
einen Pulsmodulator (24) zur Erzeugung eines pulsmodulierten Signals (PM) aus einem Digitalsignal und einen nachgeschalteten Filter (25) zur Erzeugung eines Anteils (AML) eines analogen Amplitudenmodulationssignals (AM).

19. Sendeschaltung nach Anspruch 18, **gekennzeichnet durch** separate Regelschleifen für die beiden Anteile (AMH, AML).

20. Sendeschaltung nach Anspruch 18 oder 19, **dadurch gekennzeichnet, dass** der niederfrequente Anteil (AML) an einem Versorgungsspannungseingang (3) des Sendeverstärkers (1) anliegt.

21. Sendeschaltung nach einem der Ansprüche 18 bis 20, **dadurch gekennzeichnet, dass** der höherfrequente Anteil (AMH) an einem Versorgungsspannungseingang (3) und/oder einem Vorspannungseingang (4) des Sendeverstärkers (1) anliegt.

22. Sendeschaltung nach einem der Ansprüche 18 bis 21, **gekennzeichnet durch** Schaltmittel (9, 17, 43, 44) zum Überbrücken und/oder Abschalten von Komponenten oder Baugruppen (10, 24, 45, 49).

23. Sendeschaltung nach einem der Ansprüche 18 bis 22, **gekennzeichnet durch** einen kontinuierlich arbeitenden Regelverstärker (15, 39, 46) zur Regelung des höherfrequenten Anteils (AMH).

24. Sendeschaltung nach einem der Ansprüche 18 bis 23, **gekennzeichnet durch** Mittel (8) zur bereichsweisen Korrektur einer Nichtlinearität in einer Verstärkungskennlinie des Sendeverstärkers (1) bei der Regelung des nieder-und/oder höherfrequenten Anteils in Abhängigkeit von einem Sendeleistungspegel (P).

25. Sendeschaltung nach einem der Ansprüche 18 bis 24, **gekennzeichnet durch** einen Schaltverstärker (10, 45) zur Einstellung des niederfrequenten Anteils (AML).

26. Sendeschaltung nach Anspruch 25, **dadurch** gekennz e i c hne t , dass der Schaltverstärker verschiedenen Betriebsarten aufweist, wobei eine erste Betriebsart eine Schaltverstärkung umfasst und eine zweite Betriebsart eine kontinuierliche Verstärkung umfasst, oder dass der Schaltverstärker unterschiedlich große Transistoren aufweist, die je nach Betriebsart in unterschiedlicher Kombination aktiv sind.

27. Sendeschaltung nach Anspruch 25 oder 26, **dadurch gekennzeichnet, dass** der Schaltverstärker mehrere Ausgänge aufweist.

28. Sendeschaltung nach einem der Ansprüche 18 bis 27, **gekennzeichnet durch** eine mehrere Zellen aufweisende Spannungsquelle mit Zwischenanzapfung zur Einstellung einer mittleren Versorgungsspannung für den Sendeverstärker.

29. Sendeschaltung nach Anspruch 18, **dadurch gekennzeichnet, dass** der Pulsmodulator (24) eine Zählschaltung (29, 30, 31, 32, 33, 34, 35, 36) zur Erzeugung eines pulsweiten- und/oder pulsfrequenzmodulierten Signals (PM) umfasst.

30. Sendeschaltung nach Anspruch 29, **dadurch gekennzeichnet, dass** der Pulsmodulator eine DigitalsyntheseSchaltung zur Erzeugung eines pulsfrequenzmodulierten Signals umfasst.

31. Sendeschaltung nach Anspruch 29, **dadurch gekennzeichnet, dass** der Pulsmodulator (24) einen von einem Digitalsignal angesteuerten, getakteten Frequenzteiler (31, 32, 33, 34, 35, 36) zur Erzeugung eines pulsweitenmodulierten Signals (PM) umfasst.

32. Sendeschaltung nach Anspruch 31, **dadurch gekennzeichnet, dass** der Pulsmodulator (24) mehrere Frequenzteiler (31, 32, 34, 35, 36) umfasst, die mittels Logikgattern (29, 30) untereinander verbunden sind.

33. Sendeschaltung nach einem der Ansprüche 18 bis 32, **gekennzeichnet durch** einen A/D-Wandler (21) in einem Rückkopplungszweig (18) der Regelschleife und Mittel (20) zur Durchführung eines digitalen Vergleichs von Ist- und Sollwerten für die aktuelle Amplitude.

34. Kommunikationsendgerät mit einer Sendeschaltung gemäß einem der Ansprüche 18 bis 33.

## Claims

1. Method for production of an amplitude-modulated and angle-modulated transmission signal (RFM), in which an angle-modulated input signal (RF) is applied to a first input (2) of a transmission amplifier (1) and an amplitude-modulation signal (AM) is applied to at least one second input (3, 4) of the transmission amplifier (1), and the amplitude is in this case modulated onto the input signal (RF) in the transmission amplifier (1), with the amplitude-modulation signal (AM, AMD) being processed by being split into a low-frequency component (AML) and a high-frequency component (AMH), and with the two components (AML, AMH) of the amplitude-modulation signal (AM) being combined upstream of the second input (3) of the transmission amplifier (1) or via different inputs (3, 4) of the transmission amplifier (1) in the transmission amplifier (1), and with at least one of the two components (AML, AMH) being regulated in this case,
**characterized in that** at least one component (AML) of the amplitude-modulation signal (AM) is produced from a supply voltage (VS) using a pulse-modulated signal, with the pulse-modulated signal (PM) being produced from a digital signal.

2. Method according to Claim 1, **characterized in that** both components (AML, AMH) are regulated.

3. Method according to Claim 1, **characterized in that** one of the two components (AMH) is regulated, and the other component (AML) is controlled, at least at times.

4. Method according to Claim 3, **characterized in that** the low-frequency component (AML) is controlled, at least at times.

5. Method according to one of Claims 1 to 4, **characterized in that** the high-frequency component (AMH) is regulated by means of a continuously acting regulation amplifier (15, 39, 46).

6. Method according to one of Claims 1 to 5, **characterized in that** the low-frequency component (AML) is adjusted with the aid of a switching amplifier (10, 45) or a pulse modulator (24).

7. Method according to one of Claims 1 to 5, **characterized in that** the low-frequency component corresponds to the mean supply voltage to the transmission amplifier, and **in that** the mean supply voltage is set by means of a plurality of switching amplifiers or by means of one switching amplifier with a plurality of outputs, or using a voltage source which has a plurality of cells and an intermediate tap.

8. Method according to Claim 6 or 7, **characterized in that** the low-frequency component of the amplitude-modulation signal is set by means of an amplifier which is operated in different operating modes as a function of the output power, or which has transistors of different size, which are active or inactive in a different combination depending on the operating mode, or **in that** the low-frequency component of the amplitude-modulation signal is set by means of an amplifier unit which comprises a combination of amplifiers with different operating modes, with a first operating mode comprising switching amplification and a second operating mode comprising continuous amplification, and/or **in that**, in one operating state, the higher-frequency component (AMH) is applied by a series regulator to the supply voltage (3) for the transmission amplifier (1), or in another operating state the entire amplitude-modulation signal (AM) is applied by a series regulator to the supply voltage (3) for the transmission amplifier (1), with the series regulator being followed by a switching amplifier (10, 45) or a pulse modulator (24), or by bridging over these components.

9. Method according to one of Claims 6 to 8, **characterized in that** the switching amplifier or amplifiers (10, 45) or the pulse modulator (24) is or are switched off and/or bridged for the low-frequency component (AML) of the amplitude-modulation signal (AM) when the total power required for the amplitude-modulation signal (AM) is only low, or the switching frequency of the switching amplifier (10, 45) or of the pulse modulator (24) is reduced in comparison to the switching frequency which is used when the required power is high.

10. Method according to one of Claims 1 to 9, **characterized in that** the low-frequency component (AML) is applied to a supply voltage input (3) of the transmission amplifier (1).

11. Method according to one of Claims 1 to 10, **characterized in that** the higher-frequency component (AMH) is applied to a supply voltage input (3), or to a bias voltage input (4) of the transmission amplifier (1).

12. Method according to one of Claims 1 to 11, **characterized in that**, for regulation of the low-frequency and/or higher-frequency components (AML, AMH), any non-linearity in a gain characteristic of the transmission amplifier (1) is corrected in places as a function of a transmission power level.

13. Method according to Claim 1, **characterized in that** the pulse-modulated signal (PM) comprises a pulse-width-modulated signal or a pulse-frequency-modulated signal, which is produced using a counting circuit (29, 30, 31, 32, 33, 34, 35, 36) from the digital signal.

14. Method according to Claim 13, **characterized in that** the pulse-frequency-modulated signal is produced by means of a digital synthesis circuit which is driven by a digital signal.

15. Method according to Claim 13, **characterized in that** the pulse-width-modulated signal (PM) is produced using a clocked frequency divider (31, 32, 33, 34, 35, 36) which is driven by a digital signal.

16. Method according to Claim 15, **characterized in that** the output signals from a plurality of frequency dividers (31, 32, 33, 34, 35, 36) are logically linked to one another to form a pulse-width-modulated signal (PM).

17. Method according to one of Claims 1 to 16, **characterized in that** one component (AML) of the amplitude-modulation signal (AM) is regulated by digital comparison of actual and nominal values.

18. Transmission circuit for production of an amplitude-modulated and angle-modulated transmission signal (RFM), having
a transmission amplifier (1),
means (22) for production of an angle-modulated input signal (RF), which means are designed and/or arranged in such a manner that the angle-modulated input signal (RF) is applied to a first input (2) of the transmission amplifier (1),
and means for production of an amplitude-modulation signal (AM), which are designed and/or arranged in such a manner that the amplitude-modulation signal (AM) is applied to at least one second input (3) of the transmission amplifier (1) and, in the process, the amplitude is modulated onto the input signal (RF) in the transmission amplifier (1),
means for separate processing of the amplitude-modulation signal (AM) in a low-frequency component (AML) and a higher-frequency component (AMH),
means (40) for combination of the two components (AMH, AML) of the amplitude-modulation signal (AM) upstream of the second input (3) of the transmission amplifier (1), or
means for combination of the two components (AMH, AML) of the amplitude-modulation signal (AM) in the transmission amplifier (1) via different inputs (3, 4) of the transmission amplifier (1),
and means for regulation of at least one of the two components (AMH, AML) of the amplitude-modulation signal (AM),
**characterized by**
a pulse modulator (24) for production of a pulse-modulated signal (PM) from a digital signal, and a downstream filter (25) for production of one component (AML) of an analogue amplitude-modulation signal (AM).

19. Transmission circuit according to Claim 18, **characterized by** separate control loops for the two components (AMH, AML).

20. Transmission circuit according to Claim 18 or 19, **characterized in that** the low-frequency component (AML) is applied to a supply voltage input (3) of the transmission amplifier (1).

21. Transmission circuit according to one of Claims 18 to 20, **characterized in that** the higher-frequency component (AMH) is applied to a supply voltage input (3) and/or to a bias voltage input (4) of the transmission amplifier (1).

22. Transmission circuit according to one of Claims 18 to 21, **characterized by** switching means (9, 17, 43, 44) for bridging and/or switching off components or assemblies (10, 24, 45, 49).

23. Transmission circuit according to one of Claims 18 to 22, **characterized by** a continuously operating regulation amplifier (15, 39, 46) for regulation of the higher-frequency component (AMH).

24. Transmission circuit according to one of Claims 18 to 23, **characterized by** means (8) for correction of any non-linearity in places in a gain characteristic of the transmission amplifier (1) for regulation of the low-frequency and/or higher-frequency component as a function of a transmission power level (P).

25. Transmission circuit according to one of Claims 18 to 24, **characterized by** a switching amplifier (10, 45) for setting the low-frequency component (AML).

26. Transmission circuit according to Claim 25, **characterized in that** the switching amplifier has different operating modes, with a first operating mode comprising switching amplification and a second operating mode comprising continuous amplification, or **in that** the switching amplifier has transistors of different size, which are active in different combinations depending on the operating mode.

27. Transmission circuit according to Claim 25 or 26, **characterized in that** the switching amplifier has a plurality of outputs.

28. Transmission circuit according to one of Claims 18 to 27, **characterized by** a voltage source which has a plurality of cells with an intermediate tap for setting the mean supply voltage for the transmission amplifier.

29. Transmission circuit according to Claim 18, **characterized in that** the pulse modulator (24) has a counting circuit (29, 30, 31, 32, 33, 34, 35, 36) for production of a pulse-width-modulated and/or pulse-frequency-modulated signal (PM).

30. Transmission circuit according to Claim 29, **characterized in that** the pulse modulator has a digital synthesis circuit for production of a pulse-frequency-modulated signal.

31. Transmission circuit according to Claim 29, **characterized in that** the pulse modulator (24) has a clocked frequency divider (31, 32, 33, 34, 35, 36) which is driven by a digital signal for production of a pulse-width-modulated signal (PM).

32. Transmission circuit according to Claim 31, **characterized in that** the pulse modulator (24) has a plurality of frequency dividers (31, 32, 34, 35, 36) which are connected to one another by means of logic gates (29, 30).

33. Transmission circuit according to one of Claims 18 to 32, **characterized by** an A/D converter (21) in a feedback path (18) of the control loop, and means (20) for carrying out a digital comparison of actual values and nominal values for the instantaneous amplitude.

34. Communication terminal having a transmission circuit according to one of Claims 18 to 33.

## Revendications

1. Procédé pour créer un signal d'émission modulé en amplitude et en angle (RFM), dans lequel un signal d'entrée modulé en angle (RF) est appliqué à une première entrée (2) d'un amplificateur d'émission (1) et un signal à modulation d'amplitude (AM) est appliqué à au moins une seconde entrée (3, 4) de l'amplificateur d'émission (1) et l'amplitude se trouve modulée sur le signal d'entrée (RF) dans l'amplificateur d'émission (1), le signal à modulation d'amplitude (AM, AMD) étant divisé en une composante basse fréquence (AML) et une composante haute fréquence (AMH) et les deux composantes (AML, AMH) du signal à modulation d'amplitude (AM) étant réunies dans l'amplificateur d'émission (1) avant la seconde entrée (3) de l'amplificateur d'émission (1) ou par le biais d'entrées différentes (3, 4) de l'amplificateur d'émission (1) et au moins une des deux composantes (AML, AMH) étant régulée avec ce procédé, **caractérisé en ce qu'**au moins une composante (AML) du signal à modulation d'amplitude (AM) est créée à partir d'une tension d'alimentation (VS) en utilisant un signal modulé en impulsion, le signal modulé en impulsion (PM) étant créé à partir d'un signal numérique.

2. Procédé selon la revendication 1, **caractérisé en ce que** les deux composantes (AML, AMH) sont régulées.

3. Procédé selon la revendication 1, **caractérisé en ce qu'**une des deux composantes (AMH) est régulée et l'autre composante (AML) est commandée au moins temporairement.

4. Procédé selon la revendication 3, **caractérisé en ce que** la composante basse fréquence (AML) est commandée au moins temporairement.

5. Procédé selon l'une des revendications 1 à 4, **caractérisé en ce que** la composante haute fréquence (AMH) est régulée au moyen d'un amplificateur de régulation (15, 39, 46) à fonctionnement continu.

6. Procédé selon l'une des revendications 1 à 5, **caractérisé en ce que** la composante basse fréquence (AML) est réglée à l'aide d'un amplificateur de commutation (10, 45) ou modulateur d'impulsions (24).

7. Procédé selon l'une des revendications 1 à 5, **caractérisé en ce que** la composante basse fréquence correspond à une tension d'alimentation moyenne de l'amplificateur d'émission et **en ce que** la tension d'alimentation moyenne est réglée au moyen de plusieurs amplificateurs de commutation ou au moyen d'un amplificateur de commutation à plusieurs sorties ou en utilisant une source de tension comprenant plusieurs cellules avec un branchement intermédiaire.

8. Procédé selon la revendication 6 ou 7, **caractérisé en ce que** la composante basse fréquence du signal à modulation d'amplitude est réglée au moyen d'un amplificateur qui fonctionne dans différents modes de fonctionnement en fonction de la puissance de sortie ou qui comprend des transistors de différentes tailles qui sont actifs ou inactifs selon une combinaison différente en fonction du mode de fonctionnement, ou en ce que la composante basse fréquence du signal à modulation d'amplitude est réglée au moyen d'une unité amplificatrice comprenant une combinaison d'amplificateurs ayant des modes de fonctionnement différents, un premier mode de fonctionnement comprenant une amplification de commutation et un second mode de fonctionnement comprenant une amplification continue et/ou **en ce qu'**un régulateur série de la tension d'alimentation (3) de l'amplificateur d'émission (1) alimente la composante haute fréquence (AMH) dans un état de fonctionnement ou le signal à modulation d'amplitude (AM) dans sa totalité dans un autre état de fonctionnement, le régulateur série étant monté derrière un amplificateur de commutation (10, 45) ou un modulateur d'impulsions (24) ou un court-circuit de ces éléments.

9. Procédé selon l'une des revendications 6 à 8, **caractérisé en ce que** le ou les amplificateur/s de commutation (10, 45) ou le modulateur d'impulsions (24) pour la composante basse fréquence (AML) du signal à modulation d'amplitude (AM) est/sont mis hors circuit et/ou court-circuité/s lorsqu'on a besoin seulement d'une puissance totale réduite du signal à modulation d'amplitude (AM) ou une fréquence de commutation de l'amplificateur de commutation (10, 45) ou modulateur d'impulsions (24) est abaissée par rapport à une fréquence de commutation utilisée lorsqu'on a besoin d'une puissance élevée.

10. Procédé selon l'une des revendications 1 à 9, **caractérisé en ce que** la composante basse fréquence (AML) est appliquée à une entrée de tension d'alimentation (3) de l'amplificateur d'émission (1).

11. Procédé selon l'une des revendications 1 à 10, **caractérisé en ce que** la composante haute fréquence (AMH) est appliquée à une entrée de tension d'alimentation (3) ou une entrée de prétension (4) de l'amplificateur d'émission (1).

12. Procédé selon l'une des revendications 1 à 11, **caractérisé en ce que**, lors de la régulation de la composante basse et/ou haute fréquence (AML, AMH), une non-linéarité dans une courbe d'amplification de l'amplificateur d'émission (1) est corrigée par endroits en fonction d'un niveau de puissance d'émission.

13. Procédé selon la revendication 1, **caractérisé en ce que** le signal modulé en impulsion (PM) comprend un signal modulé en largeur d'impulsions ou en fréquence d'impulsions que l'on crée à partir d'un signal numérique en utilisant un circuit de comptage (29, 30, 31, 32, 33, 34, 35, 36).

14. Procédé selon la revendication 13, **caractérisé en ce que** le signal modulé en fréquence d'impulsions est créé au moyen d'un circuit de synthèse numérique commandé par un signal numérique.

15. Procédé selon la revendication 13, **caractérisé en ce que** le signal modulé en largeur d'impulsions (PM) est créé en utilisant un diviseur de fréquence synchronisé (31, 32, 33, 34, 35, 36) commandé par un signal numérique.

16. Procédé selon la revendication 15, **caractérisé en ce que** les signaux de sortie de plusieurs diviseurs de fréquence (31, 32, 33, 34, 35, 36) sont reliés logiquement les uns aux autres pour former un signal modulé en largeur d'impulsions (PM).

17. Procédé selon l'une des revendications 1 à 16, **caractérisé en ce que** la régulation d'une composante (AML) du signal à modulation d'amplitude (AM) est exécutée grâce à une comparaison numérique de valeurs effectives et théoriques.

18. Circuit d'émission pour créer un signal d'émission modulé en amplitude et en angle (RFM), comprenant
un amplificateur d'émission (1),
des moyens (22) pour créer un signal d'entrée modulé en angle (RF) qui sont construits et/ou disposés de manière à ce que le signal d'entrée modulé en angle (RF) soit appliqué à une première entrée (2) de l'amplificateur d'émission (1),
et des moyens pour créer un signal à modulation d'amplitude (AM) qui sont construits et/ou disposés de manière à ce que le signal à modulation d'amplitude (AM) soit appliqué à au moins une seconde entrée (3) de l'amplificateur d'émission (1) et que l'amplitude se trouve modulée sur le signal d'entrée (RF) dans l'amplificateur d'émission (1),
des moyens pour traiter séparément le signal à modulation d'amplitude (AM) dans une composante basse fréquence (AML) et une composante haute fréquence (AMH),
des moyens (40) pour réunir les deux composantes (AMH, AML) du signal à modulation d'amplitude (AM) avant la seconde entrée (3) de l'amplificateur d'émission (1) ou
des moyens pour réunir les deux composantes (AMH, AML) du signal à modulation d'amplitude (AM) dans l'amplificateur d'émission (1) par le biais d'entrées différentes (3, 4) de l'amplificateur d'émission (1),
et des moyens pour réguler au moins une des deux composantes (AMH, AML) du signal à modulation d'amplitude (AM),
**caractérisé par** un modulateur d'impulsions (24) pour créer un signal modulé en impulsion (PM) à partir d'un signal numérique et un filtre (25) monté en aval pour créer une composante (AML) d'un signal à modulation d'amplitude analogique (AM).

19. Circuit d'émission selon la revendication 18, **caractérisé par** des boucles de régulation séparées pour les deux composantes (AMH, AML).

20. Circuit d'émission selon la revendication 18 ou 19, **caractérisé en ce que** la composante basse fréquence (AML) est appliquée à une entrée de tension d'alimentation (3) de l'amplificateur d'émission (1).

21. Circuit d'émission selon l'une des revendications 18 à 20, **caractérisé en ce que** la composante haute fréquence (AMH) est appliquée à une entrée de tension d'alimentation (3) et/ou à une entrée de prétension (4) de l'amplificateur d'émission (1).

22. Circuit d'émission selon l'une des revendications 18 à 21, **caractérisé par** des moyens de commutation (9, 17, 43, 44) pour court-circuiter et/ou mettre hors circuit des composants ou des sous-ensembles (10, 24, 45, 49).

23. Circuit d'émission selon l'une des revendications 18 à 22, **caractérisé par** un amplificateur de régulation (15, 39, 46) à fonctionnement continu pour la régulation de la composante haute fréquence (AMH).

24. Circuit d'émission selon l'une des revendications 18 à 23, **caractérisé par** des moyens (8) pour corriger par endroits une non-linéarité dans une courbe d'amplification de l'amplificateur d'émission (1) lors de la régulation de la composante basse et/ou haute fréquence en fonction d'un niveau de puissance d'émission (P).

25. Circuit d'émission selon l'une des revendications 18 à 24, **caractérisé par** un amplificateur de commutation (10, 45) pour le réglage de la composante basse fréquence (AML).

26. Circuit d'émission selon la revendication 25,
**caractérisé en ce que** l'amplificateur de commutation a différents modes de fonctionnement, un premier mode de fonctionnement comprenant une amplification de commutation et un second mode de fonctionnement comprenant une amplification continue, ou **en ce que** l'amplificateur de commutation comprend des transistors de différentes tailles qui sont actifs selon une combinaison différente en fonction du mode de fonctionnement.

27. Circuit d'émission selon la revendication 25 ou 26, **caractérisé en ce que** l'amplificateur de commutation est pourvu de plusieurs sorties.

28. Circuit d'émission selon l'une des revendications 18 à 27, **caractérisé par** une source de tension comprenant plusieurs cellules avec un branchement intermédiaire en vue du réglage d'une tension d'alimentation moyenne pour l'amplificateur d'émission.

29. Circuit d'émission selon la revendication 18, **caractérisé en ce que** le modulateur d'impulsions (24) comprend un circuit de comptage (29, 30, 31, 32, 33, 34, 35, 36) pour créer un signal modulé en largeur d'impulsions et/ou en fréquence d'impulsions.

30. Circuit d'émission selon la revendication 29, **caractérisé en ce que** le modulateur d'impulsions comprend un circuit de synthèse numérique pour créer un signal modulé en fréquence d'impulsions.

31. Circuit d'émission selon la revendication 29, **caractérisé en ce que** le modulateur d'impulsions (24) comprend un diviseur de fréquence synchronisé (31, 32, 33, 34, 35, 36) commandé par un signal numérique pour créer un signal modulé en largeur d'impulsions (PM).

32. Circuit d'émission selon la revendication 31,
**caractérisé en ce que** le modulateur d'impulsions (24) comprend plusieurs diviseurs de fréquence (31, 32, 34, 35, 36) qui sont reliés les uns aux autres au moyen de portes logiques (29, 30).

33. Circuit d'émission selon l'une des revendications 18 à 32, **caractérisé par** un convertisseur A/N (21) dans une branche de rétroaction (18) de la boucle de régulation et des moyens (20) pour exécuter une comparaison numérique de valeurs effectives et théoriques pour l'amplitude actuelle.

34. Terminal de communication comprenant un circuit d'émission selon l'une des revendications 18 à 33.
